# EUROPEAN PATENT APPLICATION

(11) **EP 4 250 346 A1**
(43) Date of publication of application: **27.09.2023**
(21) Application number: 21894386.8
(22) Date of filing: 14.10.2021
(51) Int. Cl.: H01L 21/8234, H01L 27/06, H01L 27/088, H01L 27/146, H04N 5/369, G01S 7/481

(54) **LIGHT-RECEIVING DEVICE AND DISTANCE MEASUREMENT DEVICE**

(30) Priority: 17.11.2020 JP 2020190841
(71) Applicant: Sony Semiconductor Solutions Corporation, Atsugi-shi, Kanagawa 243-0014 (JP)
(72) Inventor: TSUKUDA, Yasunori, Atsugi-shi, Kanagawa 243-0014 (JP)
(74) Representative: MFG Patentanwälte Meyer-Wildhagen Meggle-Freund Gerhard PartG mbB
(86) International application number: PCT/JP2021/038038
(87) International publication number: WO 2022/107512

(57) **Abstract**

A light reception device according to an embodiment of the present disclosure includes a stacked chip structure in which at least two semiconductor chips including a first semiconductor chip and a second semiconductor chip are stacked. On the first semiconductor chip, a pixel array section in which pixels each including a light-receiving element are disposed is formed. On the second semiconductor chip, a readout circuit that reads a signal to be outputted by the pixel is formed with use of a three-dimensional transistor, and a circuit using a two-dimensional transistor is formed in a region around a region where the readout circuit is formed.

## Description

### Technical Field

The present disclosure relates to a light reception device and a distance measuring device.

### Background Art

Various semiconductor devices such as a light reception device and an imaging device adopt a stacked chip structure in which a plurality of semiconductor chips are stacked in order to improve effective mounting density without increasing a mounting area (for example, see PTL 1). In addition, using a three-dimensional transistor, e.g., a FinFET in addition to adopting the stacked chip structure makes it possible to further improve effective mounting density.

### Citation List

### Patent Literature

PTL 1: Japanese Unexamined Patent Application Publication No. 2019-212918

### Summary of the Invention

Incidentally, there are cases in which a semiconductor device such as a light reception device or an imaging device uses a transistor that needs a relatively high driving voltage. A three-dimensional transistor described above, e.g., a FinFET is advantageous to a circuit of which miniaturization is demanded. However, in general, the three-dimensional transistor tends to be weak to high voltages, and is not suitable for a circuit that handles a relatively high voltage.

It is therefore desirable to provide a light reception device that properly uses a transistor advantageous to a circuit of which miniaturization is demanded and a transistor advantageous to a circuit that handles a relatively high voltage as transistors that form semiconductor chips in respective layers in adopting a stacked chip structure, and a distance measuring device including the light reception device.

A light reception device according to an embodiment of the present disclosure includes:
a stacked chip structure in which at least two semiconductor chips including a first semiconductor chip and a second semiconductor chip are stacked, in which
on the first semiconductor chip, pixels each including a light-receiving element are formed in an array, and
on the second semiconductor chip, a readout circuit that reads a signal to be outputted by the pixel is formed with use of a three-dimensional transistor, and a circuit using a two-dimensional transistor is formed in a region other than a region where the readout circuit is formed.

A distance measuring device according to an embodiment of the present disclosure includes:
a light reception device that receives reflected light from the distance measurement target on the basis of light emitted from a light source section,
the light reception device including
a stacked chip structure in which at least two semiconductor chips including a first semiconductor chip and a second semiconductor chip are stacked, in which
on the first semiconductor chip, a pixel array section in which pixels each including a light-receiving element are disposed is formed, and
on the second semiconductor chip, a readout circuit that reads a signal to be outputted by the pixel is formed with use of a three-dimensional transistor, and a circuit using a two-dimensional transistor is formed in a region around a region where the readout circuit is formed.

### Brief Description of Drawings

[FIG. 1] FIG. 1 is a schematic configuration diagram illustrating an example of a distance measuring device to which the technology according to the present disclosure is applied.
[FIG. 2] FIG. 2A and FIG. 2B are block diagrams each illustrating an example of a specific configuration of a distance measuring device according to the present application example.
[FIG. 3] FIG. 3 is a circuit diagram illustrating an example of a configuration of a basic pixel circuit in a light reception device using a SPAD element as a light-receiving element.
[FIG. 4] FIG. 4A is a characteristic diagram illustrating a current-voltage characteristic of a PN junction of the SPAD element, and FIG. 4B is a waveform diagram for description of a circuit operation of the pixel circuit.
[FIG. 5] FIG. 5A is a schematic exploded perspective view of a stacked chip structure in which a SPAD element on a pixel chip and a readout circuit on a circuit chip are disposed in a one-to-one correspondence relationship, and FIG. 5B is a schematic exploded perspective view of a stacked chip structure in which one readout circuit on a circuit chip is shared among a plurality of SPAD elements on a pixel chip.
[FIG. 6] FIG. 6A is a schematic perspective view of a structure of a FinFET, and FIG. 6B is a transverse cross sectional view of FIG. 6A.
[FIG. 7] FIG. 7A is a schematic perspective view of a structure of another three-dimensional transistor, and FIG. 7B is a transverse cross sectional view of FIG. 7A.
[FIG. 8] FIG. 8 is a schematic exploded perspective view of an example of a two-layer stacked chip structure of a light reception device according to an embodiment of the present disclosure.
[FIG. 9] FIG. 9 is a schematic exploded perspective view of an example of a three-layer stacked chip structure of the light reception device according to the embodiment of the present disclosure.
[FIG. 10] FIG. 10 is a block diagram illustrating a configuration example of a ToF distance measuring device according to Example 1.
[FIG. 11] FIG. 11 is a block diagram illustrating a configuration example of a ToF distance measuring device according to Example 2.
[FIG. 12] FIG. 12 is a block diagram illustrating a configuration example of a ToF distance measuring device according to Example 3.
[FIG. 13] FIG. 13 is a block diagram illustrating a configuration example of a ToF distance measuring device according to Example 4.
[FIG. 14] FIG. 14 is a block diagram illustrating a configuration example of a ToF distance measuring device according to Example 5.
[FIG. 15] FIG. 15 is a schematic cross-sectional view of configurations of a planar transistor used as a transistor in which a high withstand voltage is demanded, and a FinFET used as a transistor of a circuit section other than the transistor in which a high withstand voltage is demanded.
[FIG. 16] FIG. 16 is a schematic cross-sectional view of an inter-semiconductor chip coupling structure according to Example 6.
[FIG. 17] FIG. 17 is a schematic cross-sectional view of an inter-semiconductor chip coupling structure according to Example 7.
[FIG. 18] FIG. 18 is a schematic cross-sectional view of an inter-semiconductor chip coupling structure according to Example 8.
[FIG. 19] FIG. 19 is a schematic cross-sectional view of an inter-semiconductor chip coupling structure according to Example 9.
[FIG. 20] FIG. 20 is a schematic cross-sectional view of an inter-semiconductor chip coupling structure according to Example 10.
[FIG. 21] FIG. 21 is a block diagram illustrating a configuration example of a ToF distance measuring device according to a modification example.
[FIG. 22] FIG. 22 is a waveform diagram of an anode voltage and a SPAD output in a pixel circuit of the ToF distance measuring device according to the modification example.
[FIG. 23] FIG. 23 is a block diagram depicting an example of schematic configuration of a vehicle control system.
[FIG. 24] FIG. 24 is a diagram of assistance in explaining an example of installation positions of an outside-vehicle information detecting section and an imaging section.
[FIG. 25] FIG. 25 is a view depicting an example of a schematic configuration of an endoscopic surgery system.
[FIG. 26] FIG. 26 is a block diagram depicting an example of a functional configuration of a camera head and a camera control unit (CCU).

### Modes for Carrying Out the Invention

In the following, modes for carrying out the technology according to the present disclosure (hereinafter referred to as "embodiments") are described in detail with reference to the drawings. The technology according to the present disclosure is not limited to the embodiments. In the following description, the same components, or components having the same function are denoted by the same reference signs, and redundant description is omitted. It is to be noted that description is given in the following order.
1. General Description of Light Reception Device and Distance Measuring Device of Present Disclosure
2. Distance Measuring Device to Which Technology According to Present Disclosure is Applied
   2-1. Specific Configuration Example of Distance Measuring Device
   2-2. Basic Pixel Circuit Example in Light reception Device
   2-3. Circuit Operation Example of Pixel Circuit in Light reception Device
   2-4. About Stacked Chip Structure
3. Light Reception Device According to Embodiment of Present Disclosure
   3-1. Example 1 (An example in which a TDC circuit is used for time measurement: an example in which a readout circuit is a circuit section disposed below a pixel)
   3-2. Example 2 (A modification example of Example 1: an example in which the readout circuit and the TDC circuit are circuit sections disposed below the pixel)
   3-3. Example 3 (A modification example of Example 1: an example in which the readout circuit, the TDC circuit, and a histogram generator are circuit sections disposed below the pixel)
   3-4. Example 4 (An example in which a counter circuit is used for time measurement: an example in which the readout circuit is a circuit section disposed below the pixel)
   3-5. Example 5 (A modification example of Example 4: an example in which the readout circuit and the counter circuit are circuit sections disposed below the pixel)
   3-6. Example 6 (Two-layer stacked chip structure: an example in which semiconductor chips are directly joined by a junction section including a Cu-Cu direct junction or the like)
   3-7. Example 7 (A modification example of Example 6: an example in which semiconductor chips are electrically coupled with use of a silicon through electrode)
   3-8. Example 8 (Three-layer stacked chip structure: an example in which a first semiconductor chip, a second semiconductor chip, and a third semiconductor chip are stacked in this order from top)
   3-9. Example 9 (A modification example of Example 8: an example in which a top-bottom relationship of a circuit chip in a second layer is inverted)
   3-10. Example 10 (A modification Example of Example 8: an example in which the third semiconductor chip is disposed between the first semiconductor chip and the second semiconductor chip)
4. Modification Examples
5. Application Examples of Technology According to Present Disclosure
   5-1. Application Example 1 (An example of a mobile body)
   5-2. Application Example 2 (An example of an endoscopic surgery system)
6. Possible Configurations of Present Disclosure

### <General Description of Light Reception Device and Distance Measuring Device of Present Disclosure>

A light reception device and a distance measuring device of the present disclosure may have a configuration including an avalanche photodiode that operates in a Geiger mode, preferably a configuration including a single-photon avalanche diode.

The light reception device and the distance measuring device of the present disclosure including the preferred configurations described above may have a configuration in which a three-dimensional transistor includes a Fin field-effect transistor and a two-dimensional transistor includes a planar transistor.

In addition, the light reception device and the distance measuring device of the present disclosure including the preferred configurations described above may have a configuration in which a circuit using the two-dimensional transistor includes a high-voltage circuit that needs a voltage exceeding an allowable voltage of the three-dimensional transistor. In addition, the high-voltage circuit may be configured to include a voltage generation circuit that generates a voltage for the light-receiving element, or a laser driver that drives a laser light source that emits laser light to be received by the light-receiving element.

In addition, the light reception device and the distance measuring device of the present disclosure including the preferred configurations described above may have a configuration in which, in a two-layer stacked chip structure in which a first semiconductor chip and a second semiconductor chip are stacked, the first semiconductor chip and the second semiconductor chip are electrically coupled by a junction section including a Cu-Cu direct junction or a bump ball, or a silicon through electrode.

Alternatively, the light reception device and the distance measuring device of the present disclosure including the preferred configurations described above may have a configuration in which, in a three-layer stacked chip structure in which the first semiconductor chip, the second semiconductor chip, and a third semiconductor chip are stacked, a desired signal processor is formed on the third semiconductor chip. In addition, the first semiconductor chip, the second semiconductor chip, and the third semiconductor chip may be configured to be stacked in this order from top. In this case, the first semiconductor chip in a first layer and the second semiconductor chip in a second layer are electrically coupled by a silicon through electrode, and the second semiconductor chip in the second layer and the third semiconductor chip in a third layer are electrically coupled by a junction section including a Cu-Cu direct junction or a bump ball.

Alternatively, the light reception device and the distance measuring device of the present disclosure including the preferred configurations described above may have a configuration in which the third semiconductor chip is disposed between the first semiconductor chip and the second semiconductor chip. In this case, a configuration may be adopted in which the first semiconductor chip in the first layer and the third semiconductor chip in the second layer are electrically coupled by a silicon through electrode, and the third semiconductor chip in the second layer and the second semiconductor chip in the third layer are electrically coupled by a junction section including a Cu-Cu direct junction or a bump ball.

Alternatively, the light reception device and the distance measuring device of the present disclosure including the preferred configurations described above may have a configuration in which a top-bottom relationship of the second semiconductor chip in the second layer is inverted. In this case, a configuration may be adopted in which the first semiconductor chip in the first layer and the second semiconductor chip in the second layer are electrically coupled by a junction section including a Cu-Cu direct junction or a bump ball, and the second semiconductor chip in the second layer and the third semiconductor chip in the third layer are electrically coupled by a silicon through electrode.

The distance measuring device of the present disclosure may have a configuration in which distance measurement is performed by a ToF method of measuring a time until light emitted from a light source section toward a distance measurement target returns by being reflected by the distance measurement target.

### <Distance Measuring Device to Which Technology According to Present Disclosure is Applied>

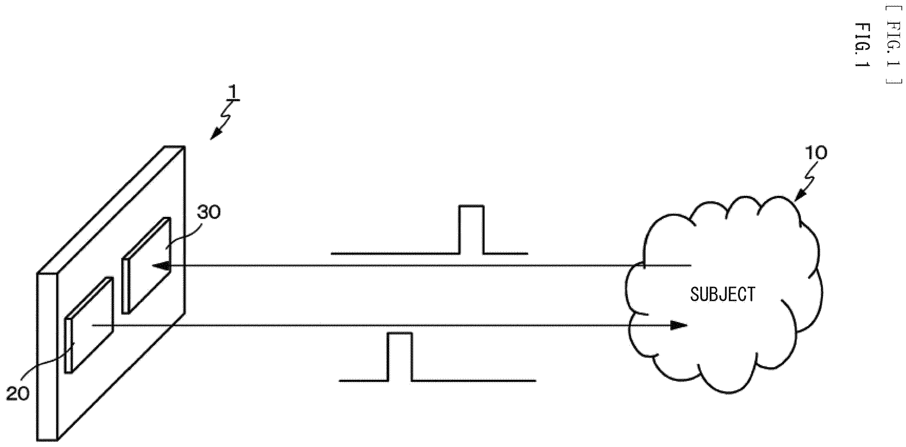

FIG. 1 is a schematic configuration diagram illustrating an example of a distance measuring device to which the technology according to the present disclosure is applied (that is, the distance measuring device of the present disclosure).

A distance measuring device 1 according to the present application example adopts, as a measurement method for measuring a distance to a subject 10 that is a distance measurement target, a ToF method of measuring a time of flight until light (e.g., laser light having a peak wavelength in an infrared wavelength region) emitted toward the subject 10 returns by being reflected by the subject 10. In order to implement distance measurement by the ToF method, the distance measuring device 1 according to the present application example includes a light source section 20 and a light reception device 30. Furthermore, as the light reception device 30, it is possible to use a light reception device according to an embodiment of the present disclosure to be described later.

### [Specific Configuration Example of Distance Measuring Device]

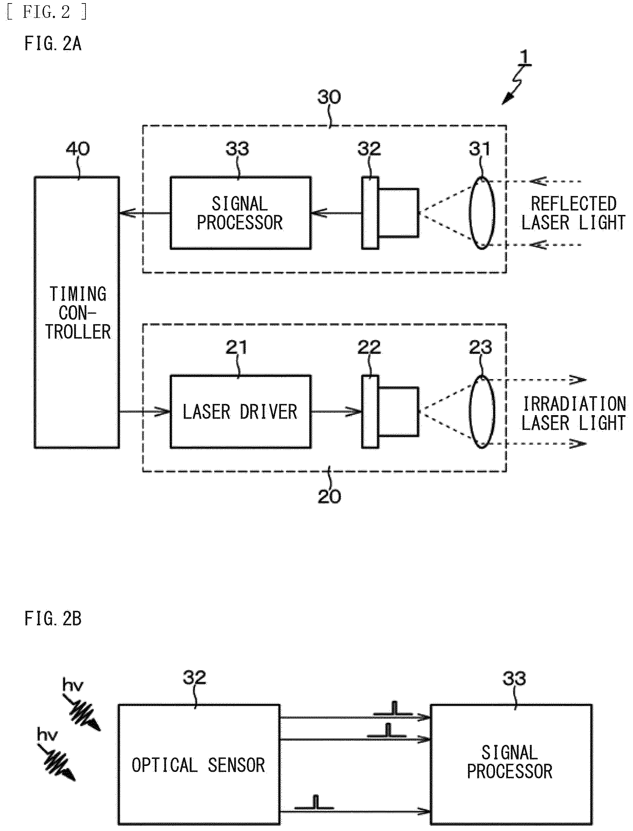

FIG. 2A and FIG. 2B each illustrate an example of a specific configuration of the distance measuring device 1 according to the present application example. The light source section 20 includes, for example, a laser driver 21, a laser light source 22, and a diffusion lens 23, and irradiates the subject 10 with laser light. The laser driver 21 drives the laser light source 22 under control by a timing controller 40. The laser light source 22 includes, for example, a laser diode, and is driven by the laser driver 21 to emit laser light. The diffusion lens 23 diffuses the laser light emitted from the laser light source 22 to irradiate the subject 10 with the laser light.

The light reception device 30 includes a light-receiving lens 31, an optical sensor 32 that is a light-receiving section, and a signal processor 33, and receives reflected laser light. The reflected laser light is irradiation laser light by the light source section 20 that returns by being reflected by the subject 10. The light-receiving lens 31 condenses the reflected laser light from the subject 10 onto a light-receiving surface of the optical sensor 32. The optical sensor 32 receives the reflected laser light from the subject 10 having passed through the light-receiving lens 31 in pixel units and performs photoelectric conversion of the reflected laser light. As the optical sensor 32, it is possible to use a two-dimensional array sensor including pixels that each include a light-receiving element and are two-dimensionally arranged in a matrix (in an array).

An output signal of the optical sensor 32 is supplied to the timing controller 40 via the signal processor 33. The timing controller 40 includes, for example, a CPU (Central Processing Unit) or the like. The timing controller 40 controls the light source section 20 and the light reception device 30, and measures a time until laser light emitted from the light source section 20 toward the subject 10 returns by being reflected by the subject 10. It is possible to determine a distance to the subject 10 on the basis of this time.

The ToF method includes an indirect (indirect) ToF method and a direct (direct) ToF method. The indirect ToF method is a method of measuring a distance to a distance measurement target by detecting a cycle in which pulse light having a predetermined cycle that is emitted from the light source section 20 is reflected by the distance measurement target (subject) and the reflected light is received by the light-receiving section and measuring the time of flight from a phase difference between a light emission cycle and a light reception cycle. The direct ToF method is a method of directly measuring a distance to the distance measurement target from a time-of-flight difference of light. In the distance measuring device 1 according to the present application example, it is possible to use, as the ToF method, any of the indirect ToF method and the direct ToF method. The time is measured by executing time measurement a plurality of times, creating a histogram by accumulating up times obtained by the plurality of times of measurement, and detecting the position of a peak of the histogram.

Then, in the distance measuring device 1 according to the present application example, a sensor in which the light-receiving element of the pixel includes an element that generates a signal in response to reception of a photon, such as an SPAD (Single Photon Avalanche Diode: single-photon avalanche diode) element, is used as the optical sensor 32. In other words, the light reception device 30 in the distance measuring device 1 according to the present application example includes a SPAD pixel sensor having a configuration in which an SPAD element is used as the light-receiving element of the pixel. The SPAD element is one kind of avalanche photodiode that increases light reception sensitivity with use of a phenomenon called avalanche multiplication, and operates in a Geiger mode in which an element is operated with a backward voltage exceeding a breakdown voltage (breakdown voltage).

It is to be noted that the SPAD element has been exemplified here as the light-receiving element (photodetection element) of the pixel, but the light-receiving element is not limited to the SPAD element. That is, as the light-receiving element of the pixel, it is possible to use any of various elements that operate in the Geiger mode, such as an APD (avalanche photodiode) and a SiPM (silicon photomultiplier), in addition to the SPAD element.

### [Basic Pixel Circuit Example in Light Reception Device]

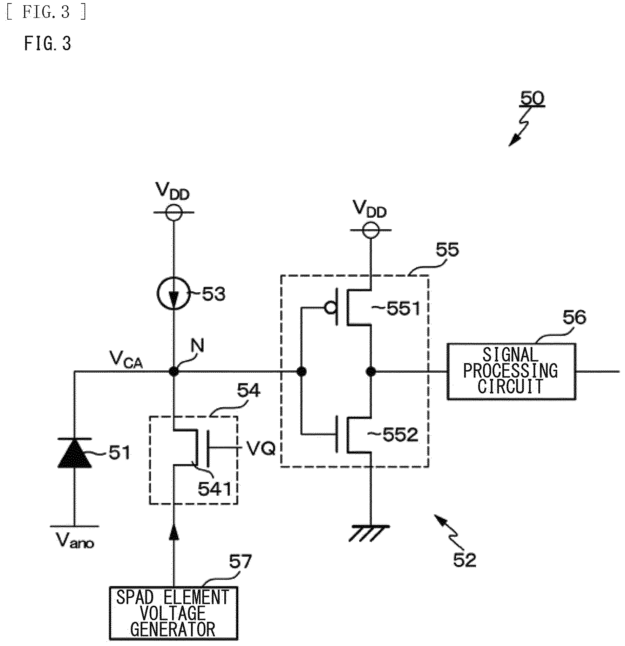

FIG. 3 illustrates an example of a configuration of a basic pixel circuit in the light reception device 30 using the SPAD element as the light-receiving element. A basic pixel circuit example for one pixel is illustrated here.

A pixel 50 of the light reception device 30 includes a SPAD element 51 that is the light-receiving element, and a readout circuit 52. The SPAD element 51 has a cathode electrode coupled to a node N, and the readout circuit 52 is coupled to the node N, and reads a signal generated by the SPAD element 51. In other words, a signal generated by the SPAD element 51 in response to reception of a photon is read as a cathode potential VCA by the readout circuit 52.

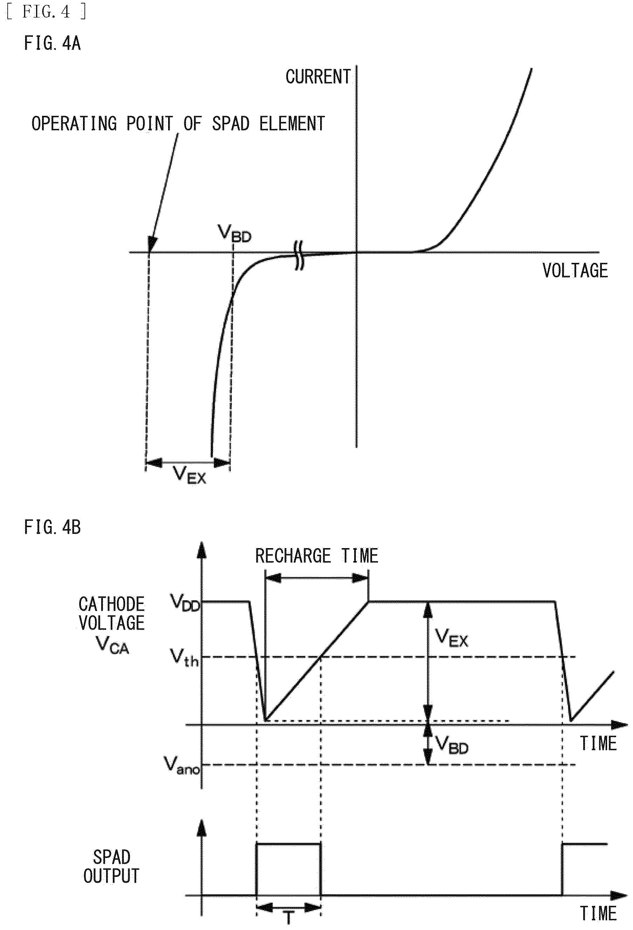

An anode voltage Vano is applied to an anode electrode of the SPAD element 51. A large negative voltage that causes avalanche multiplication, that is, a voltage (e.g., about -20 V) equal to or higher than the breakdown voltage is applied as the anode voltage Vano (see FIG. 4B).

The readout circuit 52 includes, for example, a constant current source 53, a quench circuit 54, and a pulse shaping circuit 55. A signal processing circuit 56 is provided in a stage subsequent to the readout circuit 52, more specifically in a stage subsequent to the pulse shaping circuit 55. The pixels 50 of the light reception device 30 each further include a SPAD element voltage generator 57 that generates a predetermined voltage for the SPAD element and applies the predetermined voltage as a voltage for driving the SPAD element 51 to a quench transistor 541.

The constant current source 53 is coupled between a power supply line of the power supply voltage VDD and the node N. The quench circuit 54 is a circuit that suppresses avalanche multiplication of the SPAD element 51, and includes, for example, the quench transistor 541 including an N-type MOS transistor. The quench transistor 541 has a gate electrode to which a quench control voltage VQ is applied. The quench transistor 541 sets the node N at a potential in a non-Geiger mode by the quench control voltage VQ applied to the gate electrode to thereby suppress avalanche multiplication of the SPAD element 51.

The pulse shaping circuit 55 includes, for example, a transistor circuit section including a CMOS inverter circuit that includes a P-type MOS transistor 551 and an N-type MOS transistor 552, and detects a reaction edge of the SPAD element 51. A pulse signal shaped by the pulse shaping circuit 55 is supplied to a logic circuit 55 in a subsequent stage.

The signal processing circuit 56 includes, for example, a counter circuit configured with use of a transistor, a TDC (Time-to-Digital Converter; time measuring) circuit, or the like. The TDC circuit measures a time until light emitted toward a distance measurement target returns by being reflected by the distance measurement target, on the basis of a SPAD output, that is, an output pulse of the pulse shaping circuit 55. It is to be noted that the signal processing circuit 56 may include the TDC circuit, or may include the counter circuit. The SPAD element voltage generator 57 generates the predetermined voltage for the SPAD element, and applies the predetermined voltage to the quench transistor 541.

As describe above, a voltage (e.g., about -20 V) equal to or higher than a breakdown voltage VBD is applied to the SPAD element 51. An excess volage exceeding the breakdown voltage VBD is called an excess bias voltage VEX. Characteristics of the SPAD element 51 change depending on how high the voltage value of the excess bias voltage VEX with respect to the voltage value of the breakdown voltage VBD is to be applied.

FIG. 4A illustrates an I (current)-V (voltage) characteristic of a PN junction of the SPAD element 51 that operates in the Geiger mode. FIG. 4A illustrates a relationship of the breakdown voltage VBD, the excess bias voltage VEX, and an operating point of the SPAD element 51.

### [Circuit Operation Example of Pixel Circuit in Light Reception Device]

Next, description is given of an example of a circuit operation of the pixel circuit having the configuration described above with reference to a waveform diagram in FIG. 4B.

With no current flowing through the SPAD element 51, a voltage having a value of (VDD - Vano) is applied to the SPAD element 51. This voltage value (VDD - Vano) is (VBD + VEX). Then, electrons generated at a PN junction section of the SPAD element 51 due to a dark electron generation rate DCR (Dark Count Rate) or light irradiation cause avalanche multiplication to occur, thereby generating an avalanche current. Such a phenomenon stochastically occurs even in a light-blocked state (that is, a state where no light enters). This is the dark electron generation rate DCR.

In a case where the cathode voltage VCA drops and a voltage between terminals of the SPAD element 51 becomes the breakdown voltage VBD of a PN diode, the avalanche current stops. Then, the cathode potential VCA is increased by the constant current source 53, which causes the cathode voltage VCA to recover to the power supply voltage VDD, and returns to an initial state again.

In a case where light enters the SPAD element 51 and generates even a single electron-hole pair, the pair becomes a source of generation of an avalanche current. Thus, it is possible to detect the entry of even a single photon at a certain detection efficiency PDE (Photon Detection Efficiency).

The above-described operations are repeated. In addition, in this series of operations, a waveform of the cathode voltage VCA is shaped by the pulse shaping circuit 55, and a pulse signal having a pulse width T with the arrival time of one photon as a start point becomes the SPAD output (pixel output).

### [About Stacked Chip Structure]

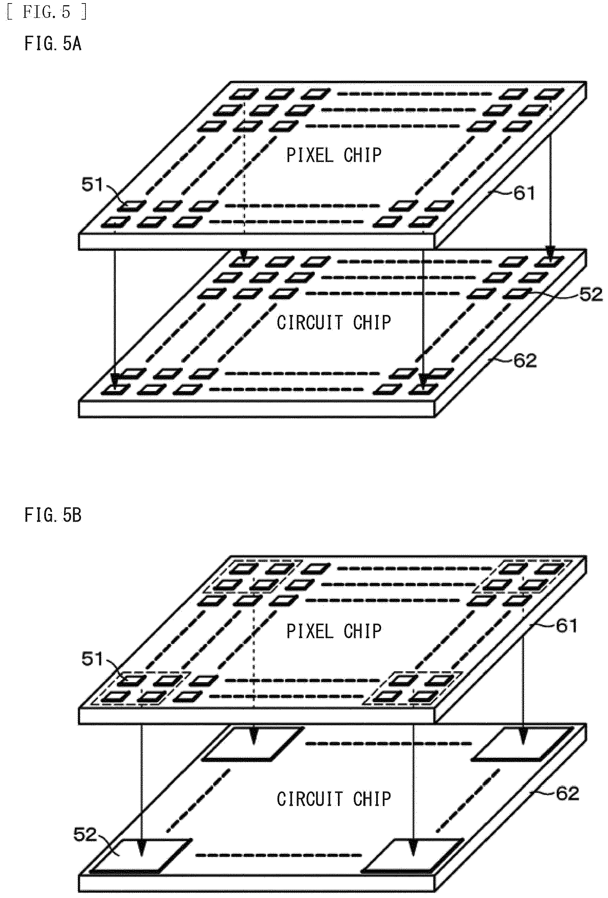

The light reception device 30 having the configuration described above, that is, the light reception device 30 using the SPAD element 51 as the light-receiving element adopts, for example, a stacked chip structure configured by stacking a plurality of semiconductor chips (semiconductor substrates) in order to improve effective mounting density without increasing a mounting area. A two-layer stacked chip structure illustrated in FIGs. 5A and 5B, that is, a stacked chip structure configured by stacking a pixel chip 61 and a circuit chip 62 is described here as one example. On the pixel chip 61, the pixel 50 including the SPAD element 51 is formed, and on the circuit chip 62, a circuit section such as the readout circuit 52 is formed. However, the stacked chip structure is not limited to a two-layer structure, and may be a stacked structure including three or more layers.

FIG. 5A is a schematic exploded perspective view of a stacked chip structure in which the SPAD elements 51 on the pixel chip 61 and the readout circuits 52 on the circuit chip 62 are disposed in a one-to-one correspondence relationship. FIG. 5B is a schematic exploded perspective view of a stacked chip structure in which one readout circuit 52 on the circuit chip 62 is shared among a plurality of SPAD elements 51 on the pixel chip 61. FIG. 5B exemplifies a case where one readout circuit 52 on the circuit chip 62 is shared among four SPAD elements 51 enclosed by a broken line on the pixel chip 61, but the number of SPAD elements 51 is not limited to four.

Adopting the stacked chip structure described above makes it possible to improve effective mounting density without increasing a mounting area, and using a three-dimensional transistor as a transistor included in the circuit section such as the readout circuit 52 in addition to adopting the stacked chip structure makes it possible to further improve effective mounting density. As the three-dimensional transistor, it is possible to exemplify, for example, a FinFET (field-effect transistor).

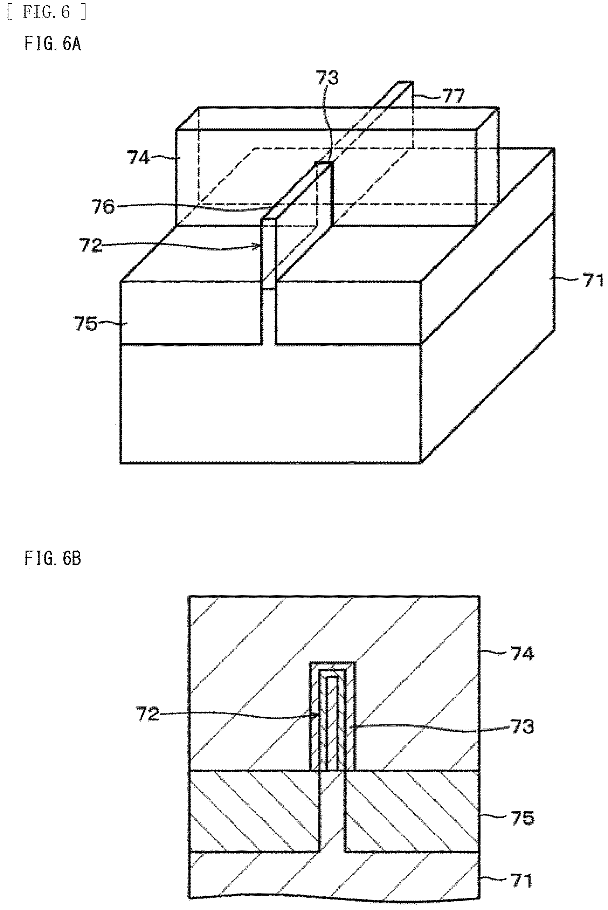

FIG. 6A illustrates a schematic perspective view of the FinFET, and FIG. 6B illustrates a transverse cross sectional view of FIG. 6A. The FinFET has a multigate structure in which both side surface sections and a top surface section of a fin (Fin) section 72 having a thin width on a silicon substrate 71 are used as a channel 73 and a gate electrode 74 is formed to stride over the fin section 72. A bottom surface section of the gate electrode 74 is in contact with an oxide 75 formed on the silicon substrate 71. Both sides between which the channel 73 is sandwiched of the fin section 72 are a source region 76 and a drain region 77.

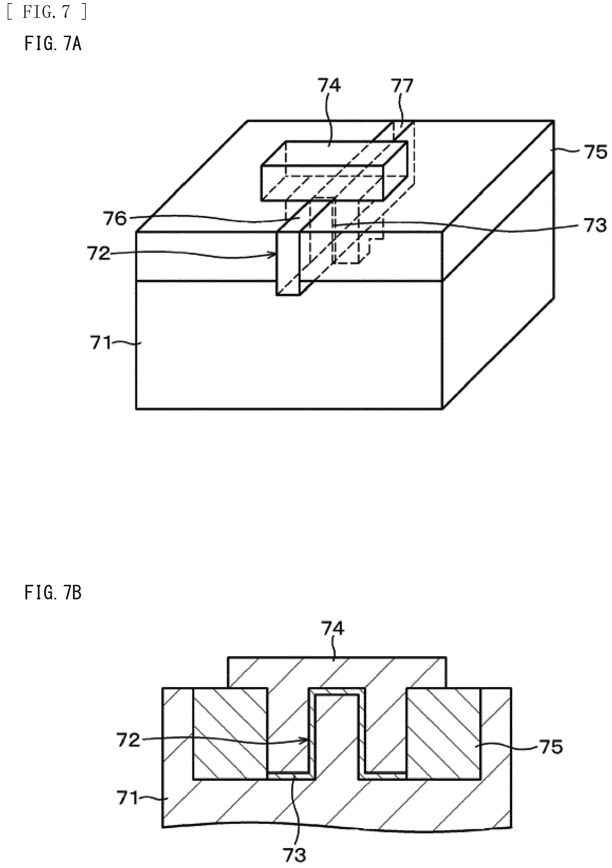

The three-dimensional transistor is not limited to the FinFET having the structure described above. FIG. 7A illustrates a schematic perspective view of another three-dimensional transistor, and FIG. 7B illustrates a transverse cross sectional view of FIG. 7A. The other three-dimensional transistor has a structure in which the bottom surface section of the gate electrode 74 is in contact with the silicon substrate 71 to form the channel 73 in the silicon substrate 71 in addition to a channel position of the FinFET described above, that is, both side surface sections and the top surface section of the fin section 72.

### <Light Reception Device According to Embodiment of Present Disclosure>

The light reception device 30 according to an embodiment of the present disclosure has a stacked chip structure configured by stacking a plurality of semiconductor chips including a semiconductor chip (semiconductor substrate) on which pixels each including the SPAD element 51 are formed in an array. In the light reception device 30, in the stacked chip structure, the circuit section such as the readout circuit 52 is formed on a semiconductor chip below the semiconductor chip on which the pixels each including the SPAD element 51 are formed in an array; however, miniaturization of a circuit section directly below the pixel is demanded. More specifically, it is possible to obtain a detailed distance image by improving distance measurement spatial resolution; however, a bottleneck in the stacked chip structure is an area of the circuit section such as the readout circuit 52 formed below the pixel. Therefore, miniaturization of the circuit section directly below the pixel is demanded. Accordingly, the light reception device 30 according to the embodiment of the present disclosure uses a three-dimensional transistor as a transistor included in the circuit section such as the readout circuit 52 of which miniaturization is demanded. It is possible for the three-dimensional transistor to reduce a mounting area necessary for the same driving force, which is extremely effective to solve the bottleneck of spatial resolution. It is possible to exemplify the FinFET illustrated in FIGs. 6A and 6B and the transistor illustrated in FIGs. 7A and 7B as the three-dimensional transistor.

Incidentally, the FinFET generally performs process creation for low voltage, and is not suitable for a transistor that configures a high-voltage circuit necessary for the distance measuring device 1 including the light reception device 30. The "high-voltage circuit" herein is a circuit that needs a voltage exceeding an allowable voltage of a three-dimensional transistor, e.g., an allowable voltage of the FinFET. It is possible to exemplify the laser driver 21 of the distance measuring device 1 illustrated in FIG. 2, the SPAD element voltage generator 57 of the light reception device 30 illustrated in FIG. 3, or the like as the high-voltage circuit necessary for the distance measuring device 1 including the light reception device 30.

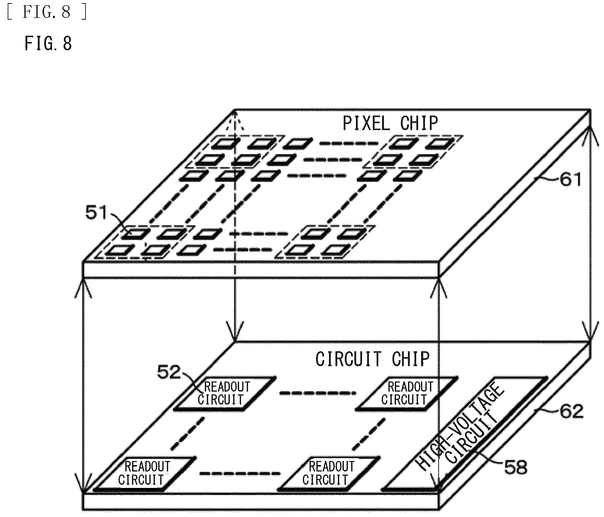

Accordingly, in the light reception device 30 according to the embodiment of the present disclosure, as illustrated in an exploded perspective view in FIG. 8, in the circuit chip 62 (second semiconductor chip) below the pixel chip 61 (first semiconductor chip) on which the pixels each including the SPAD element 51 are formed in an array, the readout circuit 52 of which miniaturization is demanded and that is disposed directly below the pixel is formed with use of a three-dimensional transistor. Furthermore, the high-voltage circuit 58, specifically, the laser driver 21 and the SPAD element voltage generator 57 are each formed with use of a two-dimensional transistor in a region other than a region where the readout circuit 52 directly below the pixel is formed. The two-dimensional transistor is a so-called planar transistor. The planar transistor may be of a SOI (Silicon On Insulator) or a CMOS process. In the planar transistor, it is easy to adjust a film thickness of a gate oxide film.

As described above, in a two-layer stacked chip structure configured by stacking the pixel chip 61 and the circuit chip 62, for the readout circuit 52 of which miniaturization is demanded and that is disposed below the pixel, a three-dimensional transistor such as a FinFET is used. In addition, the high-voltage circuit 58 such as the laser driver 21 and the SPAD element voltage generator 57 is formed with use of a two-dimensional transistor in a region other than a region where the readout circuit 52 is formed. This makes it possible to provide the light reception device 30 that is a fine SPAD pixel sensor. It is generally difficult to provide the fine SPAD pixel sensor only by a FinFET process. It is to be noted that a process of the pixel chip 61 on which the pixels each including the SPAD element 51 are formed in an array does not matter.

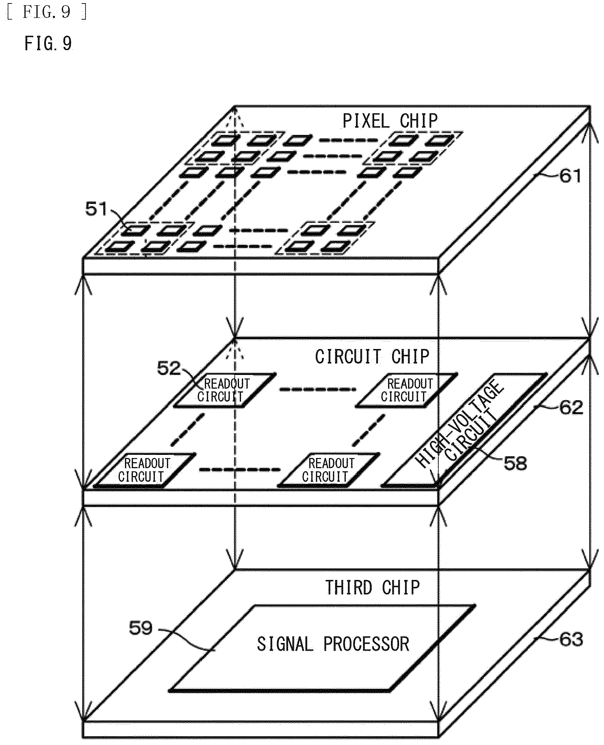

The stacked chip structure is not limited to a two-layer structure, and may be a structure including three or more layers. FIG. 9 is a schematic exploded perspective view of an example of a three-layer stacked chip structure. In a three-layer stacked chip structure configured by staking a third semiconductor chip 63 in addition to the pixel chip 61 and the circuit chip 62, the configurations of the pixel chip 61 and the circuit chip 62 are the same as those in the two-layer stacked chip structure.

That is, on the pixel chip 61, the pixels each including the SPAD element 51 are formed in an array (regardless of a process). The readout circuit 52 of which miniaturization is demanded is formed with use of a three-dimensional transistor such as a FinFET in a region directly below a pixel array of the circuit chip 62, and the high-voltage circuit 58 such as the laser driver 21 and the SPAD element voltage generator 57 is formed with use of a two-dimensional transistor in the region other than the region where the readout circuit 52 is formed.

It is possible to form a desired signal processor 59 on the third semiconductor chip 63 (regardless of a process). As the desired signal processor 59, it is possible to exemplify a circuit section such as an image recognition processing function (DNN: Deep Neural Network), super-resolution signal processing, pixel output information holding (DRAM/SRAM), a distance information computation mechanism, and a power supply control mechanism (corresponding to a PM (Power Management) IC). However, respective circuit sections exemplified here are examples, and the signal processor 59 is not limited to these circuit sections.

It is to be noted that in the three-layer stacked chip structure described above, the stacking order of the circuit chip 62 and the third semiconductor chip 63 may be reversed. In other words, a three-layer stacked chip structure may be adopted in which the third semiconductor chip 63 is a semiconductor chip in a second layer and the circuit chip 62 is a semiconductor ship in a third layer.

The following description is given of specific examples of the light reception device 30 according to the embodiment of the present disclosure that uses a three-dimensional transistor for the readout circuit 52 directly below the pixel and uses a two-dimensional transistor for a high-volage circuit formed in the region other than the region where the readout circuit 52 is formed.

### [Example 1]

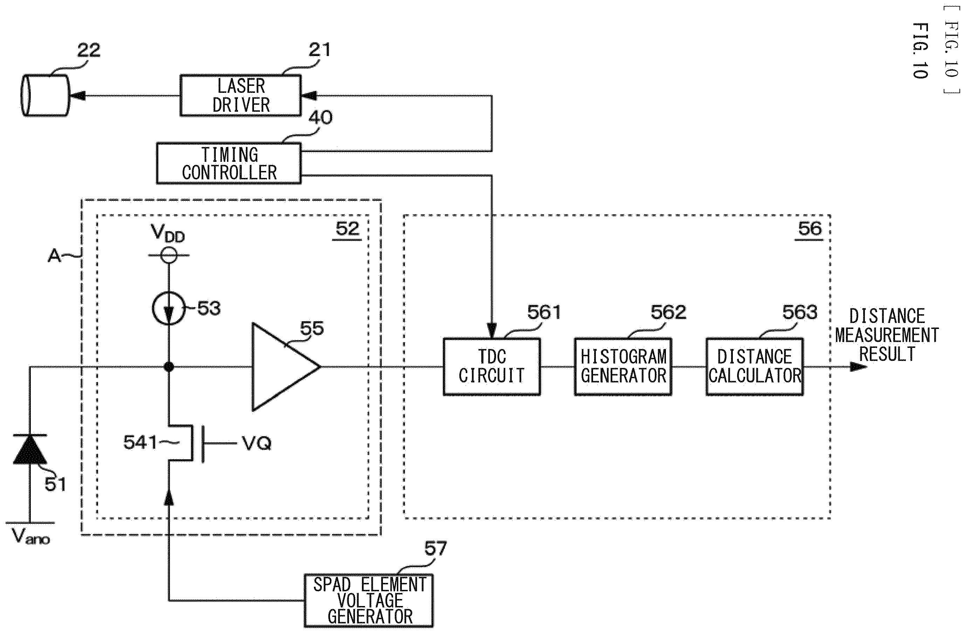

Example 1 is an example using a TDC circuit for time measurement, and is an example in which the readout circuit 52 is a circuit section disposed below a pixel. FIG. 10 illustrates a configuration example of a ToF distance measuring device according to Example 1. Here, a basic circuit example for one pixel is illustrated for a pixel circuit. This applies to examples to be described below.

In the ToF distance measuring device according to Example 1, the laser driver 21 that drives the laser light source 22, and the SPAD element voltage generator 57 that generates a voltage for driving the SPAD element 51 are each a circuit (high-voltage circuit) that needs a relatively high voltage, as compared with the readout circuit 52 and the signal processing circuit 56.

The signal processing circuit 56 provided in a stage subsequent to the readout circuit 52 includes, for example, a TDC circuit 561, a histogram generator 562, and a distance calculator 563.

The TDC circuit 561 measures a time until light emitted from the laser light source 22 toward a distance measurement target returns by being reflected by the distance measurement target, on the basis of an output of the readout circuit 52, that is, an output pulse of the pulse shaping circuit 55. The TDC circuit 561 executes time measurement a plurality of times.

The histogram generator 562 creates a histogram by accumulating up times obtained by a plurality of times of measurement by the TDC circuit 561. The SPAD element 51 is a high-performance device having extremely high sensitivity, and generates one pulse per event (causes one pulse to occur per event); therefore, it is difficult to discriminate between a disturbance light event and a reflected light event. Accordingly, execution of time measurement by the TDC circuit 561 is repeated a plurality of times, and the histogram generator 562 creates a histogram by accumulating up times obtained by a plurality of times of measurement.

The distance calculator 563 detects a time until light emitted from the laser light source 22 toward the distance measurement target returns by being reflected by the distance measurement target, on the basis of the histogram created by accumulating up times obtained by the plurality of times of measurement, calculates a distance to the distance measurement target on the basis of the detected time, and outputs the distance to the distance measurement target as a distance measurement result.

In the ToF distance measuring device according to Example 1, in a pixel circuit including the readout circuit 52, the TDC circuit 561, the histogram generator 562, and the distance calculator 563, the readout circuit 52 encircled by a broken line A in FIG. 10 is a circuit section disposed below the pixel. Then, a bottleneck in the stacked chip structure is the area of the circuit section such as the readout circuit 52 formed below the pixel; therefore, the readout circuit 52 of which miniaturization is demanded and that is disposed directly below the pixel is formed with use of a three-dimensional transistor such as a FinFET. In addition, in the region other than the region where the readout circuit 52 directly below the pixel is formed, the high-voltage circuit, specifically, the laser driver 21 and the SPAD element voltage generator 57 are formed with use of a two-dimensional transistor (planar transistor).

### [Example 2]

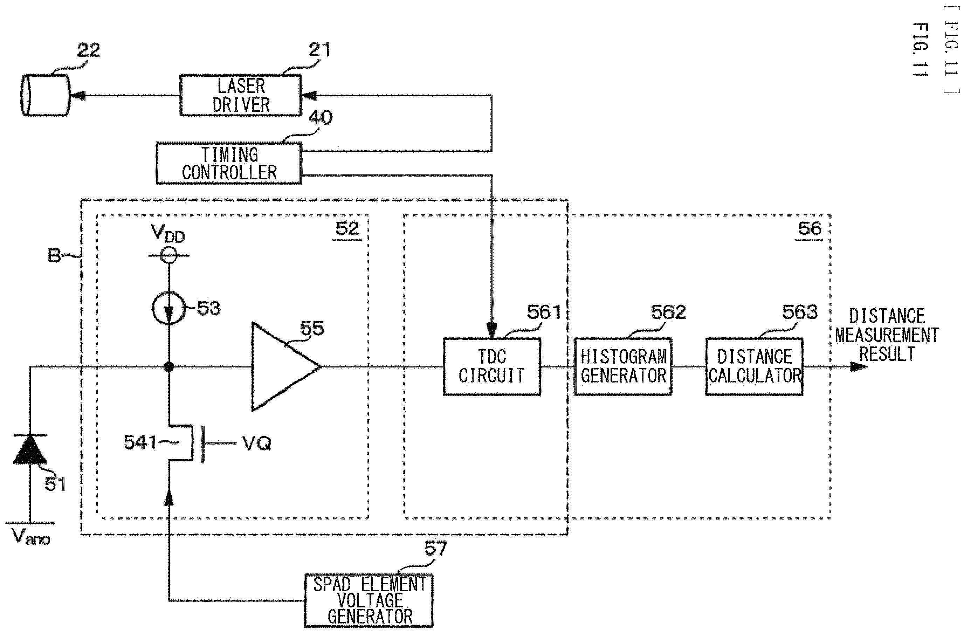

Example 2 is a modification example of Example 1, and is an example in which the readout circuit 52 and the TDC circuit 561 are circuit sections disposed below the pixel. FIG. 11 illustrates a configuration example of a ToF distance measuring device according to Example 2.

In the ToF distance measuring device according to Example 2, in a pixel circuit including the readout circuit 52, the TDC circuit 561, the histogram generator 562, and the distance calculator 563, the readout circuit 52 and the TDC circuit 561 of the signal processing circuit 56 that are encircled by a broken line B in FIG. 11 are circuit sections disposed below the pixel. Then, the readout circuit 52 and the TDC circuit 561 disposed below the pixel are formed with use of a three-dimensional transistor such as a FinFET. In addition, in the region other than the region where the readout circuit 52 directly below the pixel is formed, the laser driver 21 and the SPAD element voltage generator 57 are formed with use of a two-dimensional transistor (planar transistor), as with Example 1.

### [Example 3]

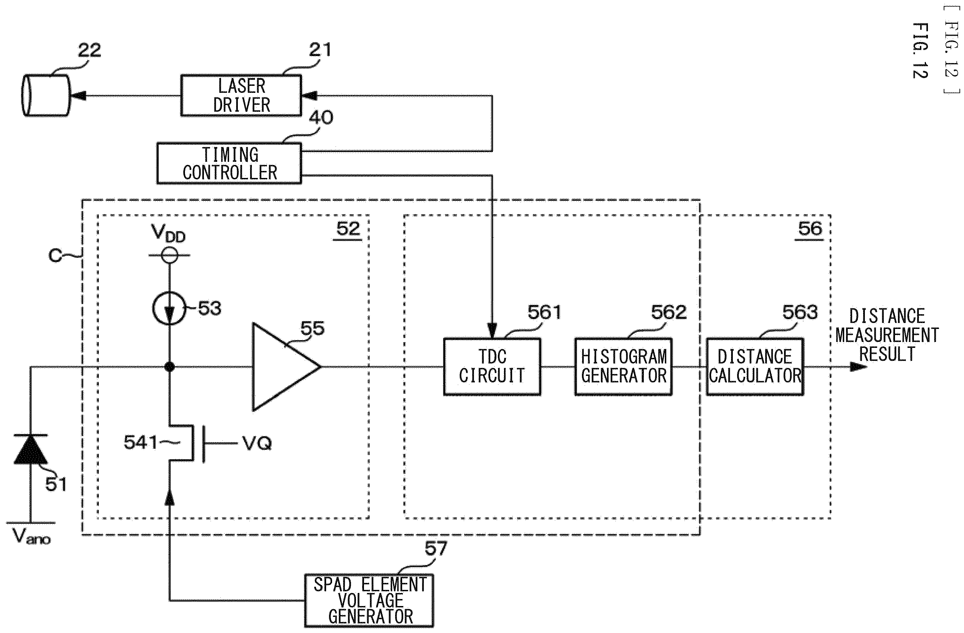

Example 3 is a modification example of Example 1, and is an example in which the readout circuit 52, the TDC circuit 561, and the histogram generator 562 are circuit sections disposed below the pixel. FIG. 12 illustrates a configuration example of a ToF distance measuring device according to Example 3.

In the ToF distance measuring device according to Example 3, in a pixel circuit including the readout circuit 52, the TDC circuit 561, the histogram generator 562, and the distance calculator 563, the readout circuit 52 and the TDC circuit 561 and the histogram generator 562 of the signal processing circuit 56 that are encircled by a broken line C in FIG. 12 are circuit sections disposed below the pixel. Then, the readout circuit 52, the TDC circuit 561, and the histogram generator 562 that are disposed below the pixel are formed with use of a three-dimensional transistor such as a FinFET. In addition, in the region other than the region where the readout circuit 52 directly below the pixel is formed, the laser driver 21 and the SPAD element voltage generator 57 are formed with use of a two-dimensional transistor (planar transistor), as with Example 1.

### [Example 4]

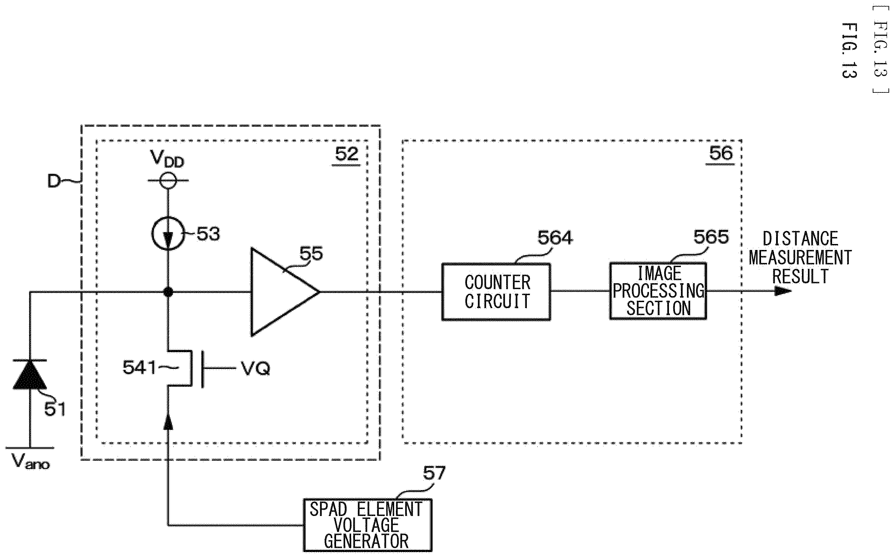

Example 4 is an example in which a counter circuit is used for time measurement, and is an example in which the readout circuit 52 is a circuit section disposed below the pixel. FIG. 13 illustrates a configuration example of a ToF distance measuring device according to Example 4.

In the ToF distance measuring device according to Example 4, the signal processing circuit 56 disposed in a stage subsequent to the readout circuit 52 includes, for example, a counter circuit 564 and an image processing calculation section 565.

The counter circuit 564 counts an output of the readout circuit 52 controlled to a state in which the SPAD element 51 is turned to the Geiger mode only for a predetermined time by the quench transistor 54, that is, an output pulse of the pulse shaping circuit 55, which makes it possible to obtain image data from a distance corresponding to the predetermined time. A timing of the quench control voltage VQ of the quench transistor 541 is sequentially changed in accordance with a necessary distance, which makes it possible to obtain an image corresponding to a time until light emitted from the laser light source 22 toward the distance measurement target returns by being reflected by the distance measurement target. The image processing calculation section 565 performs processing such as generation of a distance image and gain correction on a count result of the counter circuit 564.

In the ToF distance measuring device according to Example 4, in a pixel circuit including the readout circuit 52, the counter circuit 564, and the image processing calculation section 565, the readout circuit 52 encircled by a broken line D in FIG. 13 is a circuit section disposed below the pixel. Then, a bottleneck in the stacked chip structure is the area of the circuit section such as the readout circuit 52 formed below the pixel; therefore, the readout circuit 52 of which miniaturization is demanded and that is disposed directly below the pixel is formed with use of a three-dimensional transistor such as a FinFET. In addition, in the region other than the region where the readout circuit 52 directly below the pixel is formed, for example, the SPAD element voltage generator 57 that is a high-voltage circuit is formed with use of a two-dimensional transistor (planar transistor).

It is to be noted that a laser irradiation system including the laser light source 22 is not illustrated in FIG. 13; however, the laser driver 21 of the laser irradiation system is also a high-voltage circuit. Accordingly, the laser driver 21 may also be formed with use of a two-dimensional transistor (a planar transistor).

### [Example 5]

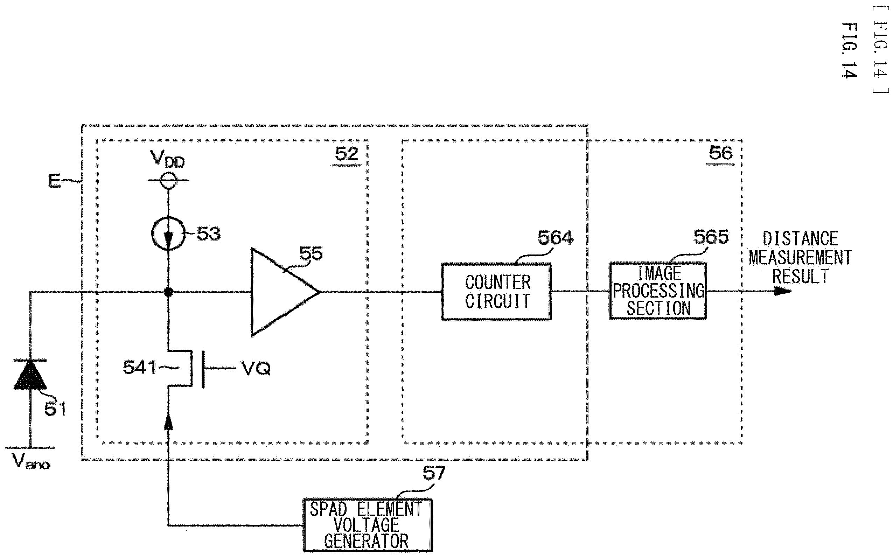

Example 5 is a modification example of Example 4, and is an example in which the readout circuit 52 and the counter circuit 564 are circuit sections disposed below the pixel. FIG. 14 illustrates a configuration example of a ToF distance measuring device according to Example 4.

In the ToF distance measuring device according to Example 5, in a pixel circuit including the readout circuit 52, the counter circuit 564, and the image processing calculation section 565, the readout circuit 52 and the counter circuit 564 of the signal processing circuit 56 that are encircled by a broken line E in FIG. 14 are circuit sections disposed below the pixel. Then, the readout circuit 52 and the counter circuit 564 disposed below the pixel are formed with use of a three-dimensional transistor such as a FinFET. In addition, in the region other than the region where the readout circuit 52 directly below the pixel is formed, for example, the SPAD element voltage generator 57 is formed with use of a two-dimensional transistor (planar transistor), as with Example 4.

It is to be noted that a laser irradiation system including the laser light source 22 is not illustrated in FIG. 14; however, as with the ToF distance measuring device according to Example 4, the laser driver 21 that is a high-voltage circuit may also be formed with use of a two-dimensional transistor (a planar transistor).

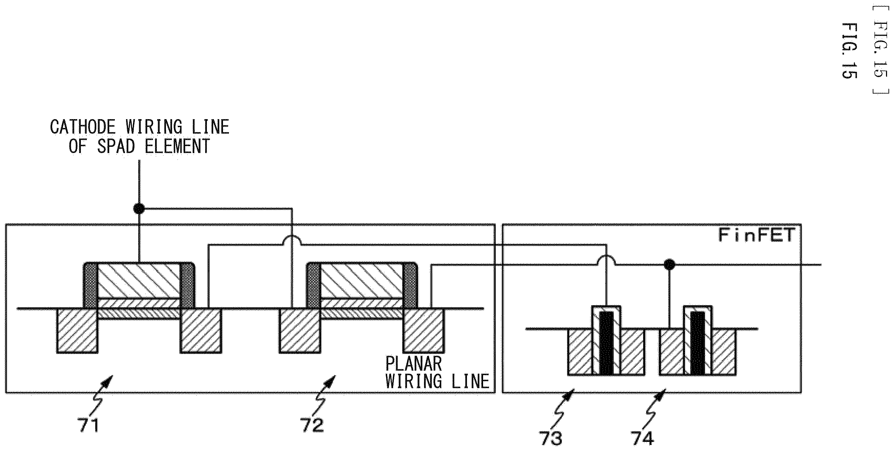

All of the transistors of the circuit sections disposed below the pixel in Example 1, Example 2, Example 3, Example 4, and Example 5 described above are not limited to a configuration in which a three-dimensional transistor such as a FinFET is used. For example, in some cases, a high withstand voltage is demanded in a transistor in contact with a cathode wiring line coupled to the SPAD element 51. Accordingly, as illustrated in FIG. 15, it is preferable to use two-dimensional transistors (planar transistors) as transistors 71 and 72 in which a high withstand voltage is demanded. In transistors 73 and 74 of the circuit section other than the transistors in which a high withstand voltage is demanded, high speed and a small area are demanded; therefore, it is preferable to use FinFETs (three-dimensional transistors) having a multigate structure in which an execution channel length is increased.

### [Example 6]

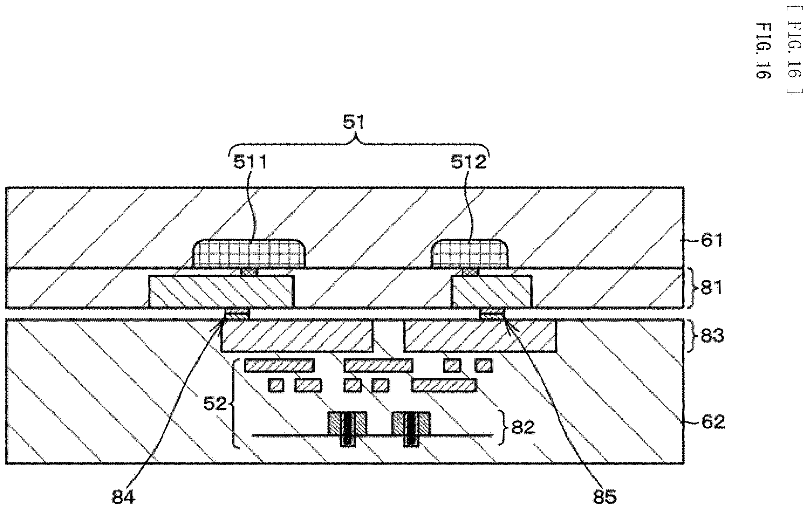

Example 6 is an example of an inter-semiconductor chip coupling structure in a two-layer stacked chip structure, and is an example in which semiconductor chips are directly joined by a junction section such as a Cu-Cu direct junction. FIG. 16 schematically illustrates the inter-semiconductor chip coupling structure according to Example 6.

In a two-layer stacked chip structure configured by stacking the pixel chip 61 that is the first semiconductor chip and the circuit chip 62 that is the second semiconductor chip, the SPAD element 51 having a cathode electrode 511 and an anode electrode 512 is formed on the pixel chip 61, and a wiring layer 81 is provided below the SPAD element 51 on side of a substrate bottom surface.

In contrast, on the circuit chip 62, the readout circuit 52 is formed with use of a three-dimensional transistor, e.g., a FinFET 82, and a wiring layer 83 is provided above the readout circuit 52 on side of a substrate top surface. Then, the pixel chip 61 in a first layer and the circuit chip 62 in a second layer are configured to be electrically coupled through junction sections 84 and 85 including a Cu-Cu direct junction, a bump ball, or the like.

### [Example 7]

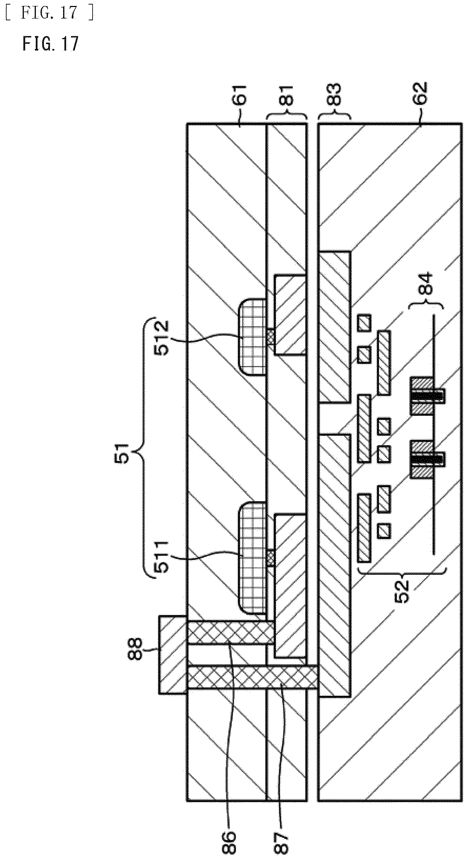

Example 7 is a modification example of Example 6, and is an example in which semiconductor chips are electrically coupled with use of a silicon through electrode. FIG. 17 schematically illustrates an inter-semiconductor chip coupling structure according to Example 7.

In the inter-semiconductor chip coupling structure according to Example 6, the pixel chip 61 and the circuit chip 62 are configured to be electrically coupled through the junction sections 84 and 85 including a Cu-Cu direct junction, a bump ball, or the like. In contrast, in the inter-semiconductor chip coupling structure according to Example 7, the pixel chip 61 in the first layer and the circuit chip 62 in the second layer are configured to be electrically coupled through an external electrode 88 with use of silicon through electrodes (Through Silicon Vias: TSV) 86 and 87. Thus, using the silicon through electrodes 86 and 87 that are mature in a process technology as compared with a Cu-Cu direct junction and the like makes it possible to provide flexibility to a combination of processes of the pixel chip 61 and the circuit chip 62.

### [Example 8]

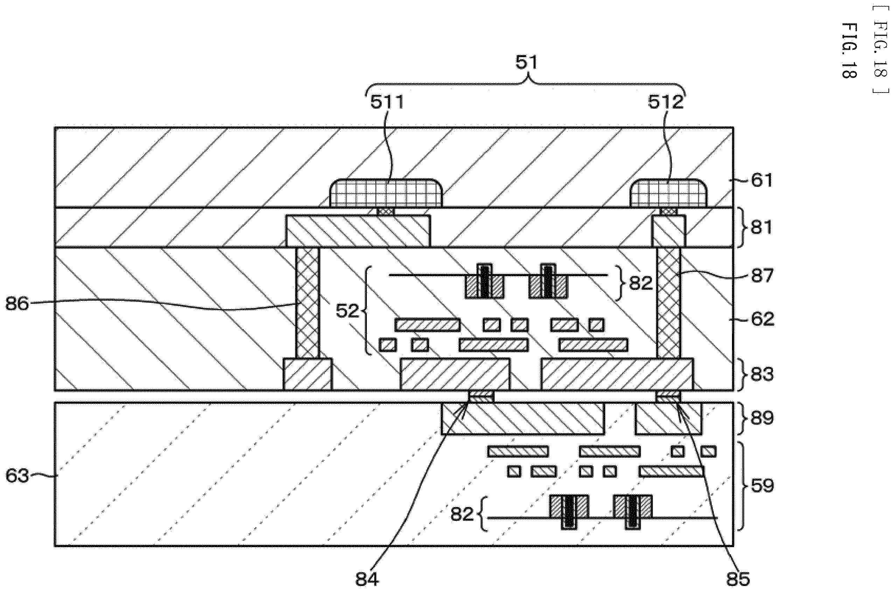

Example 8 is an example of an inter-semiconductor chip coupling structure in a three-layer stacked chip structure, and is an example in which the first semiconductor chip, the second semiconductor chip, and the third semiconductor chip are stacked in this order from top. FIG. 18 schematically illustrates an inter-semiconductor chip coupling structure according to Example 8.

The inter-semiconductor chip coupling structure according to Example 8 is a three-layer structure including the third semiconductor chip 63 in addition to the pixel chip 61 (first semiconductor chip) and the circuit chip 62 (second semiconductor chip), and has a configuration in which the pixel chip 61, the circuit chip 62, and the third semiconductor chip 63 are stacked in this order from top.

In the inter-semiconductor chip coupling structure according to Example 8, the SPAD element 51 having the cathode electrode 511 and the anode electrode 512 is formed on the pixel chip 61, and the wiring layer 81 is provided below the SPAD element 51 on side of a substrate bottom surface. On the circuit chip 62, the readout circuit 52 is formed with use of a three-dimensional transistor, e.g., the FinFET 82, and the wiring layer 83 is provided below the readout circuit 52 on side of a substrate bottom surface. Then, the pixel chip 61 in the first layer and the circuit chip 62 in the second layer are configured to be electrically coupled by the silicon through electrodes 86 and 87.

On the third semiconductor chip 63, the desired signal processor 59 described in FIG. 9, e.g., a circuit section such as an image recognition processing function (DNN), super-resolution signal processing, pixel output information holding (DRAM/SRAM), a distance information computation mechanism, and a power supply control mechanism (corresponding to a PMIC) is formed with use of, for example, the FinFET 82. The wiring layer 83 is provided above the signal processor 59 on side of a substrate top surface. Then, the circuit chip 62 in the second layer and the third semiconductor chip 63 in the third layer are configured to be electrically coupled through the junction sections 84 and 85 including a Cu-Cu direct junction, a bump ball, or the like. As compared with the silicon through electrode, the junction section including a Cu-Cu direct junction or the like allows the readout circuit 52 and the signal processor 59 to be disposed with high signal mounting density, and has a low capacitance. Accordingly, an improvement in distance measurement characteristics by high-speed and broadband signal processing is expected.

### [Example 9]

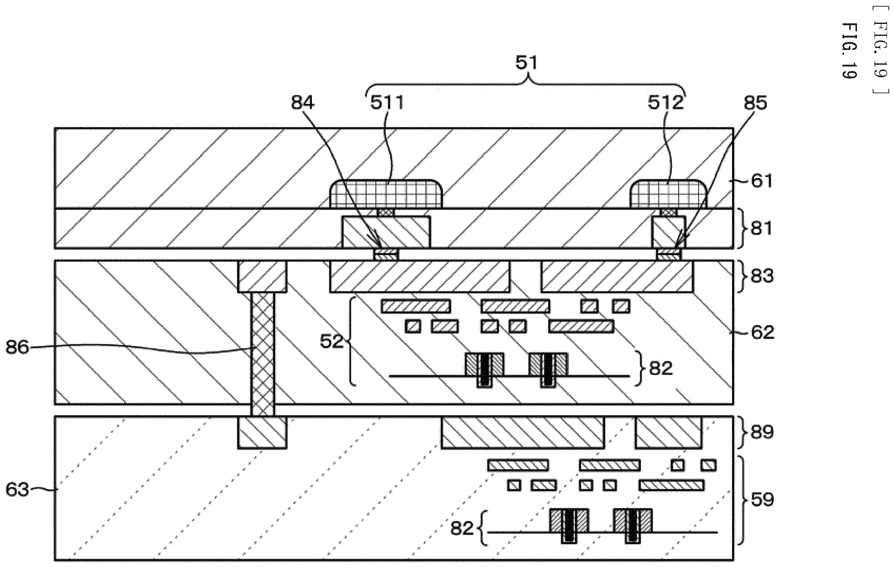

Example 9 is a modification example of Example 8, and is an example in which a top-bottom relationship of the circuit chip 62 in the second layer is inverted. FIG. 19 schematically illustrates an inter-semiconductor chip coupling structure according to Example 9.

In a three-layer stacked chip structure in which the pixel chip 61, the circuit chip 62, and the third semiconductor chip 63 are stacked in this order from top, in Example 9, the circuit chip 62 in the second layer has a configuration in which a top-bottom relationship is inverted, that is, a configuration in which the readout circuit 52 formed with use of the FinFET 82 is disposed only on the circuit chip 62 in the second layer, or is disposed dividedly on the circuit chip 62 in the second layer and the third semiconductor chip 63, and the wiring layer 83 is disposed on side of the pixel chip 61. Then, the circuit chip 62 in the first layer and the circuit chip 62 in the second layer are configured to be electrically coupled through the junction sections 84 and 85 including a Cu-Cu direct junction, a bump ball, or the like. In addition, the circuit chip 62 in the second layer and the circuit chip 62 in the third layer are configured to be electrically coupled by the silicon through electrode 86. According to this coupling configuration, it is possible to reduce a cathode capacitance, which makes it possible to expect an effect of reducing electric power consumption.

### [Example 10]

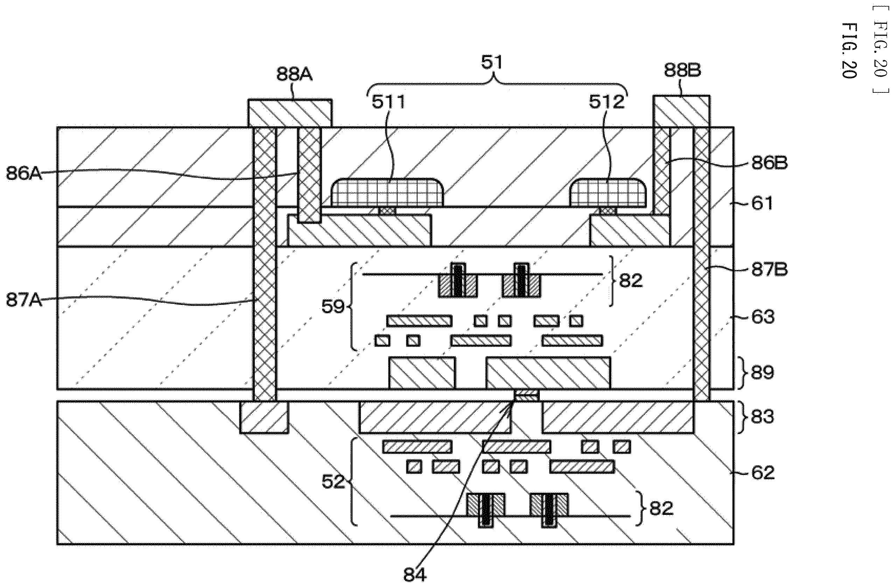

Example 10 is a modification example of Example 8, and is an example in which the third semiconductor chip is disposed between the first semiconductor chip and the second semiconductor chip. FIG. 20 schematically illustrates an inter-semiconductor chip coupling structure according to Example 10.

In the inter-semiconductor chip coupling structure according to Example 8, the pixel chip 61, the circuit chip 62, and the third semiconductor chip 63 are configured to be stacked in this order from top. In contrast, in the inter-semiconductor chip coupling structure according to Example 10, the pixel chip 61, the third semiconductor chip 63, and the circuit chip 62 are configured to be stacked in this order from top, that is, the third semiconductor chip 63 is configured to be disposed between the pixel chip 61 and the circuit chip 62.

Then, in the inter-semiconductor chip coupling structure according to Example 9, the circuit chip 62 in the first layer and the circuit chip 62 in the third layer are configured to be electrically coupled through external electrodes 88A and 88B with use of silicon through electrodes 86A, 87A, 86B, and 87B. In addition, the third semiconductor chip 63 in the second layer and the circuit chip 62 in the third layer are configured to be electrically coupled through the junction sections 84 and 85 including a Cu-Cu direct junction, a bump ball, or the like.

### <Modification Examples>

Although the technology according to the present disclosure has been described above on the basis of the preferred embodiments, the technology according to the present disclosure is not limited to the embodiments. The configuration and the structure of the light reception device and the distance measuring device described in the embodiments described above are examples and may be modified as appropriate. For example, in the embodiment described above, a so-called cathode readout pixel configuration has been exemplified in which the cathode voltage VCA of the SPAD element 51 is read by the readout circuit 52; however, a so-called anode readout pixel configuration may be adopted in which the anode voltage Vano of the SPAD element 51 is read. A distance measuring device that includes a light reception device having the anode readout pixel configuration is described below as an modification example.

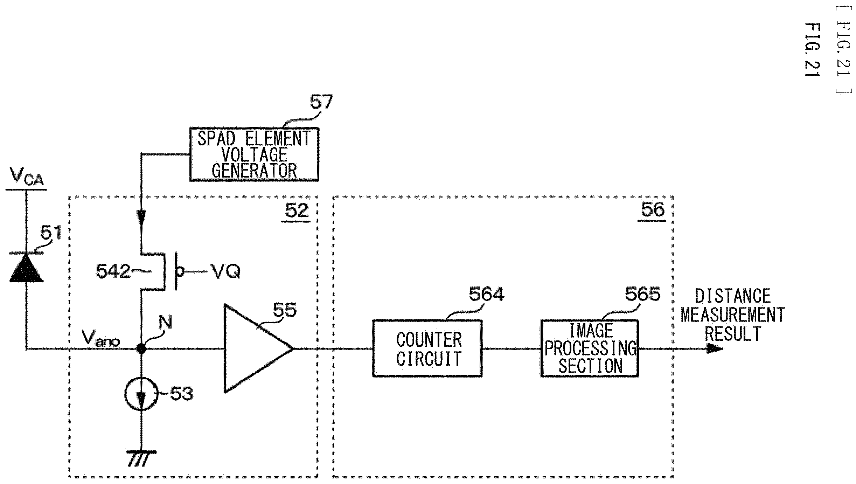

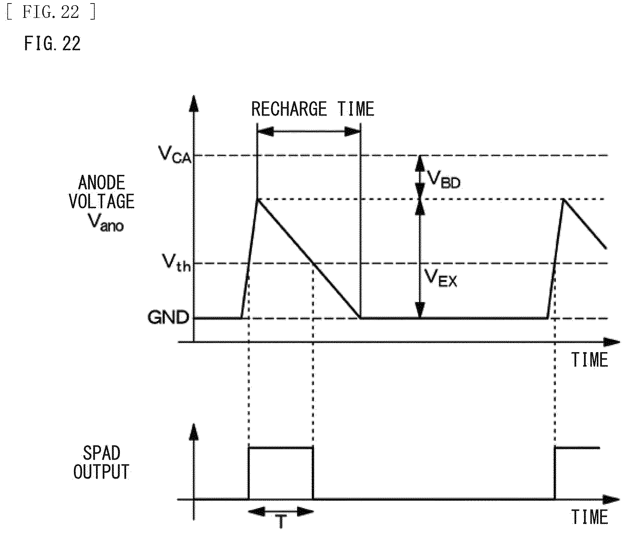

FIG. 21 illustrates a block diagram of a configuration example of a ToF distance measuring device according to the modification example. The SPAD element 51 has the cathode electrode coupled to the node of the cathode voltage VCA, and the anode electrode coupled to the node N that is an input end of the readout circuit 52. The constant current source 53 is coupled between the node N and a ground. The quench transistor 542 including a P-type MOS transistor is coupled to the node N. A voltage generated by the SPAD element voltage generator 57 that is a high-voltage circuit is applied to the quench transistor 542. FIG. 22 illustrates a waveform diagram of the anode voltage Vano and a SPAD output in a pixel circuit having the anode readout pixel configuration.

In the ToF distance measuring device according to the modification example having the anode readout pixel configuration, for example, the readout circuit 52, and the counter circuit 564 of the signal processing circuit 56 are circuit sections disposed below the pixel, and the circuit sections are formed with use of a three-dimensional transistor such as a FinFET. In addition, in the region other than the region where the readout circuit 52 directly below the pixel is formed, the SPAD element voltage generator 57 that is a high-voltage circuit is formed with use of a two-dimensional transistor (planar transistor).

It is to be noted that as a configuration example of the ToF distance measuring device according to the modification example, a configuration has been exemplified in which the signal processing circuit 56 provided in a stage subsequent to the readout circuit 52 includes the counter circuit 564 and the image processing calculation section 565; however, as with the cathode readout pixel configuration, the signal processing circuit 56 may include the TDC circuit 561, the histogram generator 562, and the distance calculator 563. In this case, as with the cathode readout pixel configuration, a circuit section disposed below the pixel is formed with use of a three-dimensional transistor such as a FinFET, and in the region other than the region where the readout circuit 52 directly below the pixel is formed, the high-voltage circuit is formed with use of a two-dimensional transistor (a planar transistor).

### <Application Examples of Technology According to Present Disclosure>

The technology according to the present disclosure is applicable to various products. A more specific application example is described below. For example, the technology according to the present disclosure may be achieved in the form of a distance measuring device to be mounted to a mobile body of any kind such as an automobile, an electric vehicle, a hybrid electric vehicle, a motorcycle, a bicycle, a personal mobility, an airplane, a drone, a vessel, a robot, a construction machine, and an agricultural machine (tractor).

### [Application Example 1: Mobile Body]

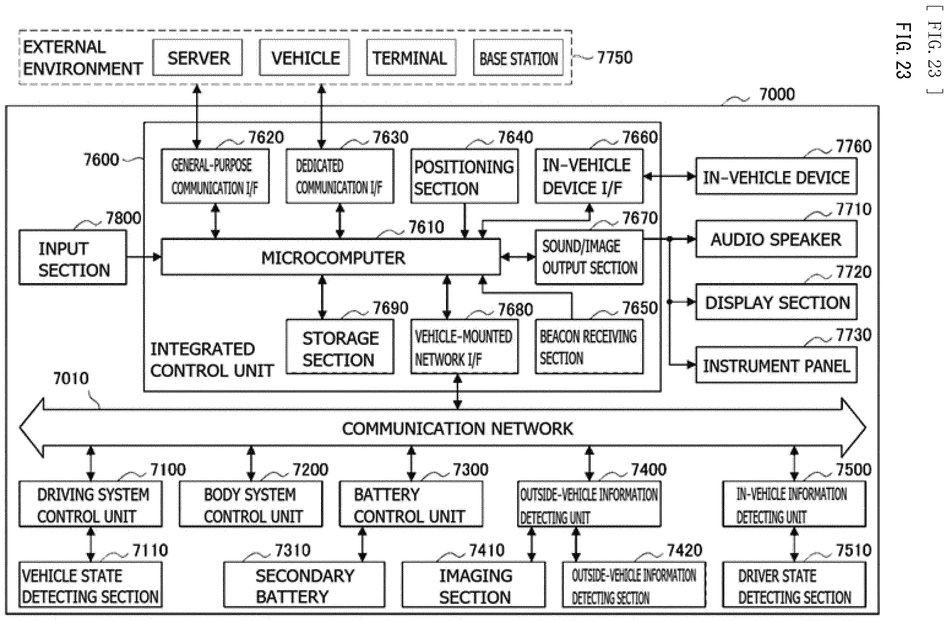

FIG. 23 is a block diagram depicting an example of schematic configuration of a vehicle control system 7000 as an example of a mobile body control system to which the technology according to an embodiment of the present disclosure can be applied. The vehicle control system 7000 includes a plurality of electronic control units connected to each other via a communication network 7010. In the example depicted in FIG. 23, the vehicle control system 7000 includes a driving system control unit 7100, a body system control unit 7200, a battery control unit 7300, an outside-vehicle information detecting unit 7400, an in-vehicle information detecting unit 7500, and an integrated control unit 7600. The communication network 7010 connecting the plurality of control units to each other may, for example, be a vehicle-mounted communication network compliant with an arbitrary standard such as controller area network (CAN), local interconnect network (LIN), local area network (LAN), FlexRay (registered trademark), or the like.

Each of the control units includes: a microcomputer that performs arithmetic processing according to various kinds of programs; a storage section that stores the programs executed by the microcomputer, parameters used for various kinds of operations, or the like; and a driving circuit that drives various kinds of control target devices. Each of the control units further includes: a network interface (I/F) for performing communication with other control units via the communication network 7010; and a communication I/F for performing communication with a device, a sensor, or the like within and without the vehicle by wire communication or radio communication. A functional configuration of the integrated control unit 7600 illustrated in FIG. 23 includes a microcomputer 7610, a general-purpose communication I/F 7620, a dedicated communication I/F 7630, a positioning section 7640, a beacon receiving section 7650, an in-vehicle device I/F 7660, a sound/image output section 7670, a vehicle-mounted network I/F 7680, and a storage section 7690. The other control units similarly include a microcomputer, a communication I/F, a storage section, and the like.

The driving system control unit 7100 controls the operation of devices related to the driving system of the vehicle in accordance with various kinds of programs. For example, the driving system control unit 7100 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like. The driving system control unit 7100 may have a function as a control device of an antilock brake system (ABS), electronic stability control (ESC), or the like.

The driving system control unit 7100 is connected with a vehicle state detecting section 7110. The vehicle state detecting section 7110, for example, includes at least one of a gyro sensor that detects the angular velocity of axial rotational movement of a vehicle body, an acceleration sensor that detects the acceleration of the vehicle, and sensors for detecting an amount of operation of an accelerator pedal, an amount of operation of a brake pedal, the steering angle of a steering wheel, an engine speed or the rotational speed of wheels, and the like. The driving system control unit 7100 performs arithmetic processing using a signal input from the vehicle state detecting section 7110, and controls the internal combustion engine, the driving motor, an electric power steering device, the brake device, and the like.

The body system control unit 7200 controls the operation of various kinds of devices provided to the vehicle body in accordance with various kinds of programs. For example, the body system control unit 7200 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 7200. The body system control unit 7200 receives these input radio waves or signals, and controls a door lock device, the power window device, the lamps, or the like of the vehicle.

The battery control unit 7300 controls a secondary battery 7310, which is a power supply source for the driving motor, in accordance with various kinds of programs. For example, the battery control unit 7300 is supplied with information about a battery temperature, a battery output voltage, an amount of charge remaining in the battery, or the like from a battery device including the secondary battery 7310. The battery control unit 7300 performs arithmetic processing using these signals, and performs control for regulating the temperature of the secondary battery 7310 or controls a cooling device provided to the battery device or the like.

The outside-vehicle information detecting unit 7400 detects information about the outside of the vehicle including the vehicle control system 7000. For example, the outside-vehicle information detecting unit 7400 is connected with at least one of an imaging section 7410 and an outside-vehicle information detecting section 7420. The imaging section 7410 includes at least one of a time-of-flight (ToF) camera, a stereo camera, a monocular camera, an infrared camera, and other cameras. The outside-vehicle information detecting section 7420, for example, includes at least one of an environmental sensor for detecting current atmospheric conditions or weather conditions and a peripheral information detecting sensor for detecting another vehicle, an obstacle, a pedestrian, or the like on the periphery of the vehicle including the vehicle control system 7000.

The environmental sensor, for example, may be at least one of a rain drop sensor detecting rain, a fog sensor detecting a fog, a sunshine sensor detecting a degree of sunshine, and a snow sensor detecting a snowfall. The peripheral information detecting sensor may be at least one of an ultrasonic sensor, a radar device, and a LIDAR device (Light detection and Ranging device, or Laser imaging detection and ranging device). Each of the imaging section 7410 and the outside-vehicle information detecting section 7420 may be provided as an independent sensor or device, or may be provided as a device in which a plurality of sensors or devices are integrated.

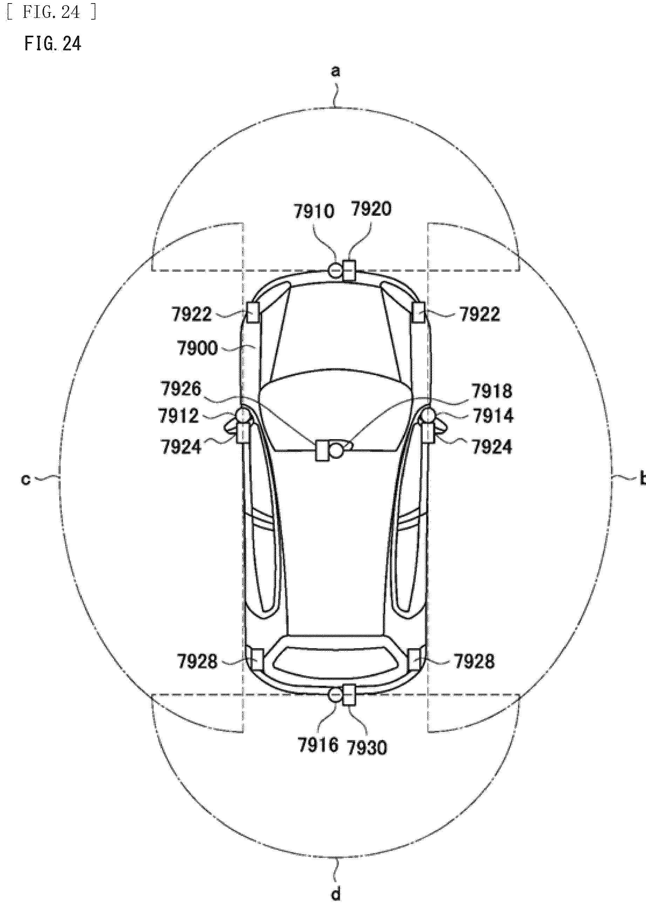

FIG. 24 depicts an example of installation positions of the imaging section 7410 and the outside-vehicle information detecting section 7420. Imaging sections 7910, 7912, 7914, 7916, and 7918 are, for example, disposed at at least one of positions on a front nose, sideview mirrors, a rear bumper, and a back door of the vehicle 7900 and a position on an upper portion of a windshield within the interior of the vehicle. The imaging section 7910 provided to the front nose and the imaging section 7918 provided to the upper portion of the windshield within the interior of the vehicle obtain mainly an image of the front of the vehicle 7900. The imaging sections 7912 and 7914 provided to the sideview mirrors obtain mainly an image of the sides of the vehicle 7900. The imaging section 7916 provided to the rear bumper or the back door obtains mainly an image of the rear of the vehicle 7900. The imaging section 7918 provided to the upper portion of the windshield within the interior of the vehicle is used mainly to detect a preceding vehicle, a pedestrian, an obstacle, a signal, a traffic sign, a lane, or the like.

Incidentally, FIG. 24 depicts an example of photographing ranges of the respective imaging sections 7910, 7912, 7914, and 7916. An imaging range a represents the imaging range of the imaging section 7910 provided to the front nose. Imaging ranges band c respectively represent the imaging ranges of the imaging sections 7912 and 7914 provided to the sideview mirrors. An imaging range d represents the imaging range of the imaging section 7916 provided to the rear bumper or the back door. A bird's-eye image of the vehicle 7900 as viewed from above can be obtained by superimposing image data imaged by the imaging sections 7910, 7912, 7914, and 7916, for example.

Outside-vehicle information detecting sections 7920, 7922, 7924, 7926, 7928, and 7930 provided to the front, rear, sides, and corners of the vehicle 7900 and the upper portion of the windshield within the interior of the vehicle may be, for example, an ultrasonic sensor or a radar device. The outside-vehicle information detecting sections 7920, 7926, and 7930 provided to the front nose of the vehicle 7900, the rear bumper, the back door of the vehicle 7900, and the upper portion of the windshield within the interior of the vehicle may be a LIDAR device, for example. These outside-vehicle information detecting sections 7920 to 7930 are used mainly to detect a preceding vehicle, a pedestrian, an obstacle, or the like.

Returning to FIG. 23, the description will be continued. The outside-vehicle information detecting unit 7400 makes the imaging section 7410 image an image of the outside of the vehicle, and receives imaged image data. In addition, the outside-vehicle information detecting unit 7400 receives detection information from the outside-vehicle information detecting section 7420 connected to the outside-vehicle information detecting unit 7400. In a case where the outside-vehicle information detecting section 7420 is an ultrasonic sensor, a radar device, or a LIDAR device, the outside-vehicle information detecting unit 7400 transmits an ultrasonic wave, an electromagnetic wave, or the like, and receives information of a received reflected wave. On the basis of the received information, the outside-vehicle information detecting unit 7400 may perform processing of detecting an object such as a human, a vehicle, an obstacle, a sign, a character on a road surface, or the like, or processing of detecting a distance thereto. The outside-vehicle information detecting unit 7400 may perform environment recognition processing of recognizing a rainfall, a fog, road surface conditions, or the like on the basis of the received information. The outside-vehicle information detecting unit 7400 may calculate a distance to an object outside the vehicle on the basis of the received information.

In addition, on the basis of the received image data, the outside-vehicle information detecting unit 7400 may perform image recognition processing of recognizing a human, a vehicle, an obstacle, a sign, a character on a road surface, or the like, or processing of detecting a distance thereto. The outside-vehicle information detecting unit 7400 may subject the received image data to processing such as distortion correction, alignment, or the like, and combine the image data imaged by a plurality of different imaging sections 7410 to generate a bird's-eye image or a panoramic image. The outside-vehicle information detecting unit 7400 may perform viewpoint conversion processing using the image data imaged by the imaging section 7410 including the different imaging parts.

The in-vehicle information detecting unit 7500 detects information about the inside of the vehicle. The in-vehicle information detecting unit 7500 is, for example, connected with a driver state detecting section 7510 that detects the state of a driver. The driver state detecting section 7510 may include a camera that images the driver, a biosensor that detects biological information of the driver, a microphone that collects sound within the interior of the vehicle, or the like. The biosensor is, for example, disposed in a seat surface, the steering wheel, or the like, and detects biological information of an occupant sitting in a seat or the driver holding the steering wheel. On the basis of detection information input from the driver state detecting section 7510, the in-vehicle information detecting unit 7500 may calculate a degree of fatigue of the driver or a degree of concentration of the driver, or may determine whether the driver is dozing. The in-vehicle information detecting unit 7500 may subject an audio signal obtained by the collection of the sound to processing such as noise canceling processing or the like.

The integrated control unit 7600 controls general operation within the vehicle control system 7000 in accordance with various kinds of programs. The integrated control unit 7600 is connected with an input section 7800. The input section 7800 is implemented by a device capable of input operation by an occupant, such, for example, as a touch panel, a button, a microphone, a switch, a lever, or the like. The integrated control unit 7600 may be supplied with data obtained by voice recognition of voice input through the microphone. The input section 7800 may, for example, be a remote control device using infrared rays or other radio waves, or an external connecting device such as a mobile telephone, a personal digital assistant (PDA), or the like that supports operation of the vehicle control system 7000. The input section 7800 may be, for example, a camera. In that case, an occupant can input information by gesture. Alternatively, data may be input which is obtained by detecting the movement of a wearable device that an occupant wears. Further, the input section 7800 may, for example, include an input control circuit or the like that generates an input signal on the basis of information input by an occupant or the like using the above-described input section 7800, and which outputs the generated input signal to the integrated control unit 7600. An occupant or the like inputs various kinds of data or gives an instruction for processing operation to the vehicle control system 7000 by operating the input section 7800.

The storage section 7690 may include a read only memory (ROM) that stores various kinds of programs executed by the microcomputer and a random access memory (RAM) that stores various kinds of parameters, operation results, sensor values, or the like. In addition, the storage section 7690 may be implemented by a magnetic storage device such as a hard disc drive (HDD) or the like, a semiconductor storage device, an optical storage device, a magneto-optical storage device, or the like.

The general-purpose communication I/F 7620 is a communication I/F used widely, which communication I/F mediates communication with various apparatuses present in an external environment 7750. The general-purpose communication I/F 7620 may implement a cellular communication protocol such as global system for mobile communications (GSM (registered trademark)), worldwide interoperability for microwave access (WiMAX (registered trademark)), long term evolution (LTE (registered trademark)), LTE-advanced (LTE-A), or the like, or another wireless communication protocol such as wireless LAN (referred to also as wireless fidelity (Wi-Fi (registered trademark)), Bluetooth (registered trademark), or the like. The general-purpose communication I/F 7620 may, for example, connect to an apparatus (for example, an application server or a control server) present on an external network (for example, the Internet, a cloud network, or a company-specific network) via a base station or an access point. In addition, the general-purpose communication I/F 7620 may connect to a terminal present in the vicinity of the vehicle (which terminal is, for example, a terminal of the driver, a pedestrian, or a store, or a machine type communication (MTC) terminal) using a peer to peer (P2P) technology, for example.

The dedicated communication I/F 7630 is a communication I/F that supports a communication protocol developed for use in vehicles. The dedicated communication I/F 7630 may implement a standard protocol such, for example, as wireless access in vehicle environment (WAVE), which is a combination of institute of electrical and electronic engineers (IEEE) 802.11p as a lower layer and IEEE 1609 as a higher layer, dedicated short range communications (DSRC), or a cellular communication protocol. The dedicated communication I/F 7630 typically carries out V2X communication as a concept including one or more of communication between a vehicle and a vehicle (Vehicle to Vehicle), communication between a road and a vehicle (Vehicle to Infrastructure), communication between a vehicle and a home (Vehicle to Home), and communication between a pedestrian and a vehicle (Vehicle to Pedestrian).

The positioning section 7640, for example, performs positioning by receiving a global navigation satellite system (GNSS) signal from a GNSS satellite (for example, a GPS signal from a global positioning system (GPS) satellite), and generates positional information including the latitude, longitude, and altitude of the vehicle. Incidentally, the positioning section 7640 may identify a current position by exchanging signals with a wireless access point, or may obtain the positional information from a terminal such as a mobile telephone, a personal handyphone system (PHS), or a smart phone that has a positioning function.

The beacon receiving section 7650, for example, receives a radio wave or an electromagnetic wave transmitted from a radio station installed on a road or the like, and thereby obtains information about the current position, congestion, a closed road, a necessary time, or the like. Incidentally, the function of the beacon receiving section 7650 may be included in the dedicated communication I/F 7630 described above.

The in-vehicle device I/F 7660 is a communication interface that mediates connection between the microcomputer 7610 and various in-vehicle devices 7760 present within the vehicle. The in-vehicle device I/F 7660 may establish wireless connection using a wireless communication protocol such as wireless LAN, Bluetooth (registered trademark), near field communication (NFC), or wireless universal serial bus (WUSB). In addition, the in-vehicle device I/F 7660 may establish wired connection by universal serial bus (USB), high-definition multimedia interface (HDMI (registered trademark)), mobile high-definition link (MHL), or the like via a connection terminal (and a cable if necessary) not depicted in the figures. The in-vehicle devices 7760 may, for example, include at least one of a mobile device and a wearable device possessed by an occupant and an information device carried into or attached to the vehicle. The in-vehicle devices 7760 may also include a navigation device that searches for a path to an arbitrary destination. The in-vehicle device I/F 7660 exchanges control signals or data signals with these in-vehicle devices 7760.

The vehicle-mounted network I/F 7680 is an interface that mediates communication between the microcomputer 7610 and the communication network 7010. The vehicle-mounted network I/F 7680 transmits and receives signals or the like in conformity with a predetermined protocol supported by the communication network 7010.

The microcomputer 7610 of the integrated control unit 7600 controls the vehicle control system 7000 in accordance with various kinds of programs on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. For example, the microcomputer 7610 may calculate a control target value for the driving force generating device, the steering mechanism, or the braking device on the basis of the obtained information about the inside and outside of the vehicle, and output a control command to the driving system control unit 7100. For example, the microcomputer 7610 may perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like. In addition, the microcomputer 7610 may perform cooperative control intended for automated driving, which makes the vehicle to travel automatedly without depending on the operation of the driver, or the like, by controlling the driving force generating device, the steering mechanism, the braking device, or the like on the basis of the obtained information about the surroundings of the vehicle.

The microcomputer 7610 may generate three-dimensional distance information between the vehicle and an object such as a surrounding structure, a person, or the like, and generate local map information including information about the surroundings of the current position of the vehicle, on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. In addition, the microcomputer 7610 may predict danger such as collision of the vehicle, approaching of a pedestrian or the like, an entry to a closed road, or the like on the basis of the obtained information, and generate a warning signal. The warning signal may, for example, be a signal for producing a warning sound or lighting a warning lamp.

The sound/image output section 7670 transmits an output signal of at least one of a sound and an image to an output device capable of visually or auditorily notifying information to an occupant of the vehicle or the outside of the vehicle. In the example of FIG. 23, an audio speaker 7710, a display section 7720, and an instrument panel 7730 are illustrated as the output device. The display section 7720 may, for example, include at least one of an on-board display and a head-up display. The display section 7720 may have an augmented reality (AR) display function. The output device may be other than these devices, and may be another device such as headphones, a wearable device such as an eyeglass type display worn by an occupant or the like, a projector, a lamp, or the like. In a case where the output device is a display device, the display device visually displays results obtained by various kinds of processing performed by the microcomputer 7610 or information received from another control unit in various forms such as text, an image, a table, a graph, or the like. In addition, in a case where the output device is an audio output device, the audio output device converts an audio signal constituted of reproduced audio data or sound data or the like into an analog signal, and auditorily outputs the analog signal.

Incidentally, at least two control units connected to each other via the communication network 7010 in the example depicted in FIG. 23 may be integrated into one control unit. Alternatively, each individual control unit may include a plurality of control units. Further, the vehicle control system 7000 may include another control unit not depicted in the figures. In addition, part or the whole of the functions performed by one of the control units in the above description may be assigned to another control unit. That is, predetermined arithmetic processing may be performed by any of the control units as long as information is transmitted and received via the communication network 7010. Similarly, a sensor or a device connected to one of the control units may be connected to another control unit, and a plurality of control units may mutually transmit and receive detection information via the communication network 7010.

An example of the vehicle control system to which the technology according to the present disclosure may be applied has been described above. In the technology according to the present disclosure, in a case where the imaging section 7410 or the outside-vehicle information detecting section 7420 among the components described above includes a ToF camera (ToF sensor), it is possible to use, as the ToF camera, a light reception device that is a fine SPAD pixel sensor. It is difficult to implement the fine SPAD pixel sensor only by a FinFET process. Accordingly, mounting the light reception device as a ToF camera of a distance measuring device makes it possible to construct a compact vehicle control system.

### [Application Example 2: Endoscopic Surgery System]

In addition, for example, the technology according to the present disclosure may be applied to an endoscopic surgery system.

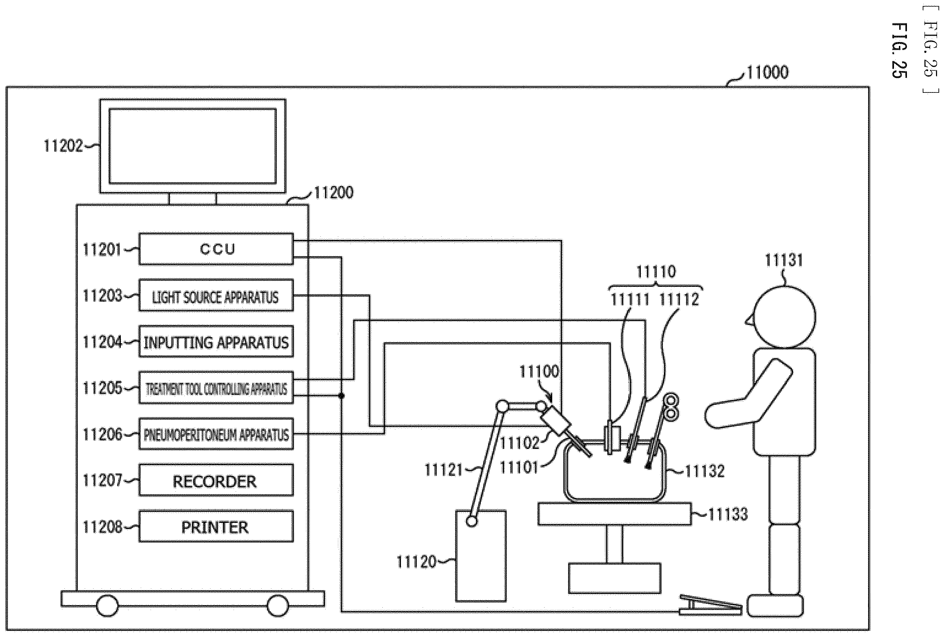

FIG. 25 is a view depicting an example of a schematic configuration of an endoscopic surgery system to which the technology according to an embodiment of the present disclosure (present technology) can be applied.

In FIG. 25, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

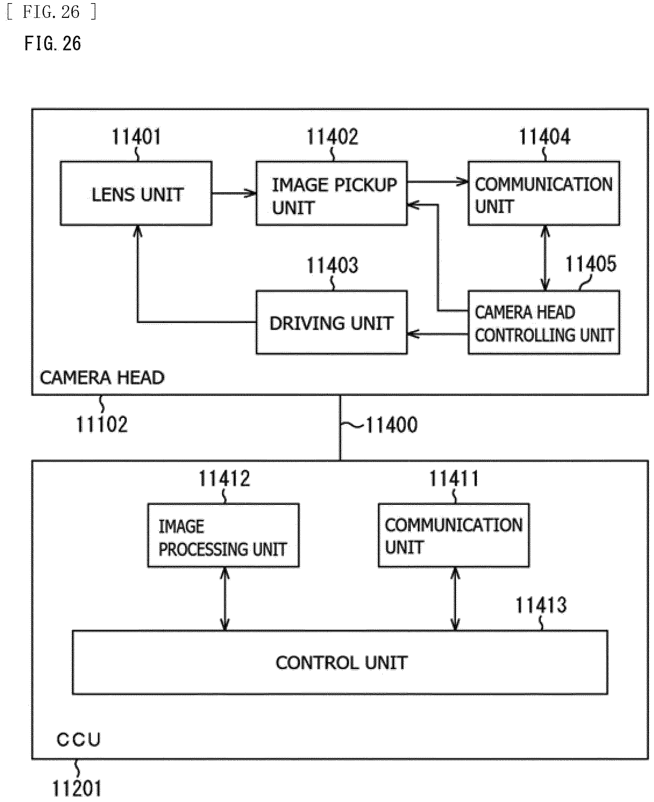

FIG. 26 is a block diagram depicting an example of a functional configuration of the camera head 11102 and the CCU 11201 depicted in FIG. 25.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technology according to the present disclosure may be applied has been described above. The technology according to the present disclosure may be applied to the camera head 11102 among the components described above. Specifically, in a case where the camera head 11102 includes a distance measuring device that measures a distance to an affected part, it is possible to use, as a ToF camera of the distance measuring device, a light reception device that is a fine SPAD pixel sensor. It is difficult to implement the fine SPAD pixel sensor only by a FinFET process. Accordingly, mounting the light reception device as the ToF camera of the distance measuring device makes it possible to construct an compact endoscopic surgery system.

It is to be noted that while the description has been given here of the endoscopic surgery system as one example, the technology according to the present disclosure may also be applied to, for example, a micrographic surgery system and the like.

### <Possible Configurations of Present Disclosure>

It is to be noted that the present disclosure may also have the following configurations.

### <<A. Light Reception Device>>>

[A-01] A light reception device including:
   a stacked chip structure in which at least two semiconductor chips including a first semiconductor chip and a second semiconductor chip are stacked, in which
   on the first semiconductor chip, pixels each including a light-receiving element are formed in an array, and
   on the second semiconductor chip, a readout circuit that reads a signal to be outputted by the pixel is formed with use of a three-dimensional transistor, and a circuit using a two-dimensional transistor is formed in a region other than a region where the readout circuit is formed.
[A-02] The light reception device according to [A-01], in which the light-receiving element includes an avalanche photodiode that operates in a Geiger mode.
[A-03] The light reception device according to [A-02], in which the light-receiving element includes a single-photon avalanche diode.
[A-04] The light reception device according to any one of [A-01] to [A-03], in which the three-dimensional transistor includes a Fin field-effect transistor.
[A-05] The light reception device according to any one of [A-01] to [A-04], in which the two-dimensional transistor includes a planar transistor.
[A-06] The light reception device according to any one of [A-01] to [A-05], in which the circuit using the two-dimensional transistor includes a high-voltage circuit that needs a voltage exceeding an allowable voltage of the three-dimensional transistor.
[A-07] The light reception device according to [A-06], in which the high-voltage circuit includes a voltage generation circuit that generates a voltage for the light-receiving element.
[A-08] The light reception device according to [A-06], in which the high-voltage circuit include a laser driver that drives a laser light source that emits laser light to be received by the light-receiving element.
[A-09] The light reception device according to any one of [A-01] to [A-08], in which, in a two-layer stacked chip structure in which the first semiconductor chip and the second semiconductor chip are stacked, the first semiconductor chip and the second semiconductor chip are electrically coupled by a junction section including a Cu-Cu direct junction or a bump ball, or a silicon through electrode.
[A-10] The light reception device according to any one of [A-01] to [A-08], in which, in a three-layer stacked chip structure in which the first semiconductor chip, the second semiconductor chip, and a third semiconductor chip are stacked, a desired signal processor is formed on the third semiconductor chip.
[A-11] The light reception device according to [A-10], in which the first semiconductor chip, the second semiconductor chip, and the third semiconductor chip are stacked in this order from top.
[A-12] The light reception device according to [A-11], in which
   the first semiconductor chip in a first layer and the second semiconductor chip in a second layer are electrically coupled by a silicon through electrode, and
   the second semiconductor chip in the second layer and the third semiconductor chip in a third layer are electrically coupled by a junction section including a Cu-Cu direct junction or a bump ball.
[A-13] The light reception device according to [A-10], in which the third semiconductor chip is disposed between the first semiconductor chip and the second semiconductor chip.
[A-14] The light reception device according to [A-13], in which
   the first semiconductor chip in a first layer and the third semiconductor chip in a second layer are electrically coupled by a silicon through electrode, and
   the third semiconductor chip in the second layer and the second semiconductor chip in a third layer are electrically coupled by a junction section including a Cu-Cu direct junction or a bump ball.
[A-15] The light reception device according to [A-13], in which the second semiconductor chip in a second layer has a configuration in which a top-bottom relationship is inverted. [A-16]
   The light reception device according to [A-15], in which
   the first semiconductor chip in a first layer and the second semiconductor chip in the second layer are electrically coupled by a junction section including a Cu-Cu direct junction or a bump ball, and
   the second semiconductor chip in the second layer and the third semiconductor chip in a third layer are electrically coupled by a silicon through electrode.

### <<B. Distance Measuring Device>>

[B-01] A distance measuring device including:
   a light source section that emits light toward a distance measurement target; and
   a light reception device that receives reflected light from the distance measurement target on the basis of the light emitted from the light source section,
   the light reception device including
   a stacked chip structure in which at least two semiconductor chips including a first semiconductor chip and a second semiconductor chip are stacked, in which
   on the first semiconductor chip, a pixel array section in which pixels each including a light-receiving element are disposed is formed, and
   on the second semiconductor chip, a readout circuit that reads a signal to be outputted by the pixel is formed with use of a three-dimensional transistor, and a circuit using a two-dimensional transistor is formed in a region around a region where the readout circuit is formed.
[B-02] The distance measuring device according to [B-01], in which the light-receiving element includes an avalanche photodiode that operates in a Geiger mode.
[B-03] The distance measuring device according to [B-02], in which the light-receiving element includes a single-photon avalanche diode.
[B-04] The distance measuring device according to any one of [B-01] to [B-03], in which the three-dimensional transistor includes a Fin field-effect transistor.
[B-05] The distance measuring device according to any one of [B-01] to [B-04], in which the two-dimensional transistor includes a planar transistor.
[B-06] The distance measuring device according to any one of [B-01] to [B-05], in which the circuit using the two-dimensional transistor includes a high-voltage circuit that needs a voltage exceeding an allowable voltage of the three-dimensional transistor.
[B-07] The distance measuring device according to [B-06], in which the high-voltage circuit includes a voltage generation circuit that generates a voltage for the light-receiving element.
[B-08] The distance measuring device according to [B-06], in which the high-voltage circuit includes a laser driver that drives a laser light source that emits laser light to be received by the light-receiving element.
[B-09] The distance measuring device according to any one of [B-01] to [B-08], in which, in a two-layer stacked chip structure in which the first semiconductor chip and the second semiconductor chip are stacked, the first semiconductor chip and the second semiconductor chip are electrically coupled by a junction section including a Cu-Cu direct junction or a bump ball, or a silicon through electrode.
[B-10] The distance measuring device according to any one of [B-01] to [B-08], in which, in a three-layer stacked chip structure in which the first semiconductor chip, the second semiconductor chip, and a third semiconductor chip are stacked, a desired signal processor is formed on the third semiconductor chip.
[B-11] The distance measuring device according to [B-10], in which the first semiconductor chip, the second semiconductor chip, and the third semiconductor chip are stacked in this order from top.
[B-12] The distance measuring device according to [B-11], in which
   the first semiconductor chip in a first layer and the second semiconductor chip in a second layer are electrically coupled by a silicon through electrode, and
   the second semiconductor chip in the second layer and the third semiconductor chip in a third layer are electrically coupled by a junction section including a Cu-Cu direct junction or a bump ball.
[B-13] The distance measuring device according to [B-10], in which the third semiconductor chip is disposed between the first semiconductor chip and the second semiconductor chip.
[B-14] The distance measuring device according to [B-13], in which
   the first semiconductor chip in a first layer and the third semiconductor chip in a second layer are electrically coupled by a silicon through electrode, and
   the third semiconductor chip in the second layer and the second semiconductor chip in a third layer are electrically coupled by a junction section including a Cu-Cu direct junction or a bump ball.
[B-15] The distance measuring device according to [B-13], in which the second semiconductor chip in a second layer has a configuration in which a top-bottom relationship is inverted.
[B-16] The distance measuring device according to [B-15], in which
   the first semiconductor chip in a first layer and the second semiconductor chip in the second layer are electrically coupled by a junction section including a Cu-Cu direct junction or a bump ball, and
   the second semiconductor chip in the second layer and the third semiconductor chip in a third layer are electrically coupled by a silicon through electrode.
[B-17] The distance measuring device according to any one of [B-01] to [B-16], in which distance measurement is performed by a ToF method of measuring a time until the light emitted from the light source section toward the distance measurement target returns by being reflected by the distance measurement target.

This application claims the priority on the basis of Japanese Patent Application No. 2020-190841 filed on November 17, 2020 with Japan Patent Office, the entire contents of which are incorporated in this application by reference.

It should be understood by those skilled in the art that various modifications, combinations, sub-combinations, and alterations may occur depending on design requirements and other factors insofar as they are within the scope of the appended claims or the equivalents thereof.

## Claims

1. A light reception device comprising:
a stacked chip structure in which at least two semiconductor chips including a first semiconductor chip and a second semiconductor chip are stacked, wherein
on the first semiconductor chip, pixels each including a light-receiving element are formed in an array, and
on the second semiconductor chip, a readout circuit that reads a signal to be outputted by the pixel is formed with use of a three-dimensional transistor, and a circuit using a two-dimensional transistor is formed in a region other than a region where the readout circuit is formed.

2. The light reception device according to claim 1, wherein the light-receiving element includes an avalanche photodiode that operates in a Geiger mode.

3. The light reception device according to claim 2, wherein the light-receiving element includes a single-photon avalanche diode.

4. The light reception device according to claim 1, wherein the three-dimensional transistor comprises a Fin field-effect transistor.

5. The light reception device according to claim 1, wherein the two-dimensional transistor comprises a planar transistor.

6. The light reception device according to claim 1, wherein the circuit using the two-dimensional transistor comprises a high-voltage circuit that needs a voltage exceeding an allowable voltage of the three-dimensional transistor.

7. The light reception device according to claim 6, wherein the high-voltage circuit comprises a voltage generation circuit that generates a voltage for the light-receiving element.

8. The light reception device according to claim 6, wherein the high-voltage circuit comprises a laser driver that drives a laser light source that emits laser light to be received by the light-receiving element.

9. The light reception device according to claim 1, wherein, in a two-layer stacked chip structure in which the first semiconductor chip and the second semiconductor chip are stacked, the first semiconductor chip and the second semiconductor chip are electrically coupled by a junction section including a Cu-Cu direct junction or a bump ball, or a silicon through electrode.

10. The light reception device according to claim 1, wherein, in a three-layer stacked chip structure in which the first semiconductor chip, the second semiconductor chip, and a third semiconductor chip are stacked, a desired signal processor is formed on the third semiconductor chip.

11. The light reception device according to claim 10, wherein the first semiconductor chip, the second semiconductor chip, and the third semiconductor chip are stacked in this order from top.

12. The light reception device according to claim 11, wherein
the first semiconductor chip in a first layer and the second semiconductor chip in a second layer are electrically coupled by a silicon through electrode, and
the second semiconductor chip in the second layer and the third semiconductor chip in a third layer are electrically coupled by a junction section including a Cu-Cu direct junction or a bump ball.

13. The light reception device according to claim 10, wherein the third semiconductor chip is disposed between the first semiconductor chip and the second semiconductor chip.

14. The light reception device according to claim 13, wherein
the first semiconductor chip in a first layer and the third semiconductor chip in a second layer are electrically coupled by a silicon through electrode, and
the third semiconductor chip in the second layer and the second semiconductor chip in a third layer are electrically coupled by a junction section including a Cu-Cu direct junction or a bump ball.

15. The light reception device according to claim 13, wherein the second semiconductor chip in a second layer has a configuration in which a top-bottom relationship is inverted.

16. The light reception device according to claim 15, wherein
the first semiconductor chip in a first layer and the second semiconductor chip in the second layer are electrically coupled by a junction section including a Cu-Cu direct junction or a bump ball, and
the second semiconductor chip in the second layer and the third semiconductor chip in a third layer are electrically coupled by a silicon through electrode.

17. A distance measuring device comprising:
a light source section that emits light toward a distance measurement target; and
a light reception device that receives reflected light from the distance measurement target on a basis of the light emitted from the light source section,
the light reception device including
a stacked chip structure in which at least two semiconductor chips including a first semiconductor chip and a second semiconductor chip are stacked, wherein
on the first semiconductor chip, a pixel array section in which pixels each including a light-receiving element are disposed is formed, and
on the second semiconductor chip, a readout circuit that reads a signal to be outputted by the pixel is formed with use of a three-dimensional transistor, and a circuit using a two-dimensional transistor is formed in a region around a region where the readout circuit is formed.

18. The distance measuring device according to claim 17, wherein distance measurement is performed by a ToF method of measuring a time until the light emitted from the light source section toward the distance measurement target returns by being reflected by the distance measurement target.
